(19) Europäisches Patentamt
European Patent Office
Office européen des brevets

(11) EP 3 733 746 B1

# (12) EUROPEAN PATENT SPECIFICATION

(45) Date of publication and mention of the grant of the patent:
**27.08.2025 Bulletin 2025/35**

(21) Application number: **18894398.9**

(22) Date of filing: **25.12.2018**

(51) International Patent Classification (IPC):
***H05K 1/02*** *(2006.01)* ***C08L 63/04*** *(2006.01)*
***C08G 59/68*** *(2006.01)* ***C08G 59/40*** *(2006.01)*
***B32B 5/26*** *(2006.01)* ***B32B 5/02*** *(2006.01)*
***B32B 15/20*** *(2006.01)* ***B32B 15/14*** *(2006.01)*
***H05K 3/46*** *(2006.01)* ***H05K 1/03*** *(2006.01)*
***C08L 61/26*** *(2006.01)* ***C08J 5/24*** *(2006.01)*
***C08G 59/62*** *(2006.01)* ***C08G 59/32*** *(2006.01)*

(52) Cooperative Patent Classification (CPC):
(C-Sets available)
**H05K 1/0366; B32B 5/022; B32B 5/024; B32B 5/26; B32B 15/14; B32B 15/20; C08G 59/3218; C08G 59/4042; C08G 59/621; C08G 59/686; C08J 5/244; C08J 5/249; C08L 61/26; C08L 63/04; H05K 1/0373;** (Cont.)

(86) International application number:
**PCT/JP2018/047428**

(87) International publication number:
**WO 2019/131574 (04.07.2019 Gazette 2019/27)**

## (54) RESIN COMPOSITION, PREPREG, LAMINATE, METAL FOIL-CLAD LAMINATE, PRINTED WIRING BOARD, AND MULTILAYER PRINTED WIRING BOARD

HARZZUSAMMENSETZUNG, PREPREG, LAMINAT, METALLFOLIENKASCHIERTES LAMINAT, LEITERPLATTE UND MEHRSCHICHTIGE LEITERPLATTE

COMPOSITION DE RÉSINE, PRÉIMPRÉGNÉ, STRATIFIÉ, STRATIFIÉ PLAQUÉ D’UNE FEUILLE MÉTALLIQUE, CARTE DE CIRCUIT IMPRIMÉ, ET CARTE DE CIRCUIT IMPRIMÉ MULTICOUCHE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **27.12.2017 JP 2017250350**

(43) Date of publication of application:
**04.11.2020 Bulletin 2020/45**

(73) Proprietor: **MITSUBISHI GAS CHEMICAL COMPANY, INC.**
**Chiyoda-ku**
**Tokyo 100-8324 (JP)**

(72) Inventors:
- **HAMAJIMA, Tomoki**
  **Tokyo 125-8601 (JP)**
- **ITO, Meguru**
  **Tokyo 125-8601 (JP)**
- **KUBO, Takashi**
  **Tokyo 125-8601 (JP)**
- **MORISHITA, Tomoe**
  **Tokyo 125-8601 (JP)**
- **SHIGA, Eisuke**
  **Tokyo 125-8601 (JP)**

(74) Representative: **Hoffmann Eitle**
**Patent- und Rechtsanwälte PartmbB**
**Arabellastraße 30**
**81925 München (DE)**

(56) References cited:
**EP-A1- 2 557 121** **EP-A1- 2 947 122**
**WO-A1-2017/187783** **WO-A1-2018/124158**
**JP-A- 2013 129 827** **JP-A- 2017 193 614**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**JP-A- 2017 193 614** **US-A1- 2015 017 450**
**US-A1- 2016 108 230**

- **DATABASE WPI Week 201774, 26 October 2017 Derwent World Patents Index; AN 2017-727602, XP002804676**

(52) Cooperative Patent Classification (CPC): (Cont.)
B32B 2250/03; B32B 2250/40; B32B 2260/023; B32B 2260/046; B32B 2262/0269; B32B 2262/0276; B32B 2262/101; B32B 2307/202; B32B 2307/206; B32B 2307/732; B32B 2457/08; C08J 2363/00; C08L 2205/025; H05K 1/0271; H05K 3/4655

C-Sets
**C08L 63/04, C08L 83/04, C08K 3/36**

## Description

### Technical Field

The present invention relates to a resin composition, a prepreg, a laminate, a metal foil-clad laminate, a printed wiring board, and a multilayer printed wiring board.

### Background Art

As semiconductor packages widely used in electronic devices, communication devices, personal computers, and the like have become increasingly sophisticated and miniaturized in recent years, high integration and high-density packaging of components for semiconductor packages have been increasingly accelerated in recent years. Accordingly, various characteristics required for a printed wiring board for a semiconductor package have become increasingly severe. Characteristics required for such a printed wiring board include, for example, low water absorption, moisture absorption heat resistance, flame retardancy, low dielectric constant, low dielectric loss tangent, low coefficient of thermal expansion, heat resistance, chemical resistance, and high plating peel strength. In addition to these, suppressing the warpage of printed wiring boards (achieving low warpage) has recently become an important issue, and various studies have been made.

For example, Patent Literature 1 discloses a resin composition comprising an imidazole compound having a specific structure, an epoxy compound, a phenolic compound, and a maleimide compound for the purpose of simultaneously satisfying a low thermal expansion property, a high glass transition temperature, a flame retardancy, and a high degree of curing even when cured at a low temperature. In the examples of document, it is disclosed that a copper foil laminate formed by using a prepreg obtained by impregnating and coating an E glass woven fabric with the above resin composition has an excellent low coefficient of thermal expansion, a high glass transition temperature, a flame retardancy, a high degree of curing, a high moisture absorption heat resistance, and a high peel strength. On the other hand, the document does not discuss the suppression of the warpage of the printed wiring board (achieving low warpage).

Patent Literature 2 discloses a resin composition comprising a non-halogen epoxy resin, a biphenyl aralkyl-based phenolic resin, a maleimide compound, and an inorganic filler for the purpose of simultaneously satisfying excellent heat resistance, reflow resistance, drilling workability, and low water absorption while retaining excellent flame retardancy without using a halogen compound or a phosphorus compound. In the examples of the document, it is disclosed that a copper-clad laminate formed by using a prepreg obtained by impregnating and coating an E glass woven fabric with the above-described resin composition has an excellent flame retardancy, a water absorption rate, a heat resistance, a reflow resistance, and drilling workability. On the other hand, the document also does not discuss the suppression of the warpage of the printed wiring board (achieving low warpage).

Patent Literature 3 discloses a prepreg comprising a thermosetting resin composition containing a fibrous base material and a filler in a predetermined ratio and having a surface glossiness of a specific value or more measured under predetermined measurement conditions for the purpose of suppressing the appearance abnormality (molding streak) that occurs when heated and press-molded using a resin composition having a high filler content. The document discloses that when the storage modulus E' at 25°C after curing under predetermined conditions is set to 13 to 50 GPa or less, and the storage modulus E' at 260°C is set to 5 to 20 GPa, the occurrence of molding streak can be suppressed. On the other hand, the document also does not discuss the suppression of the warpage of the printed wiring board (achieving low warpage).

Patent Literature 4 discloses a prepreg comprising a predetermined epoxy resin, a predetermined phenolic resin, a low elastic component, and an inorganic filler in a predetermined ratio, and having a glass transition temperature (Tg) after curing of 220°C and having an elastic modulus at 260°C of 10 GPa or less for the purpose of reducing the amount of warpage of a semiconductor package caused by a temperature change even when the thickness of a printed wiring board is small. However, the document also does not discuss the suppression of the warpage of the printed wiring board (achieving low warpage).

Patent Literature 5 discloses a laminate comprising a base material and a thermosetting resin composition, in which the thermosetting resin composition contains an epoxy resin containing an aromatic ring skeleton, a coefficient of linear expansion of the laminate at a predetermined temperature is within a predetermined range, a storage modulus at 30°C thereof is 22 to 40 GPa, and a storage modulus at 180°C thereof is 10 to 18 GPa for the purpose of reducing the warpage in a manufacturing process of a multilayer printed wiring board and a manufacturing process of semiconductor device. The document discloses that when the coefficient of linear expansion and the storage modulus at a predetermined temperature are within the above ranges, the warpage of the multilayer printed wiring board is reduced, and the warpage of the multilayer printed wiring board portion is thus reduced in the manufacturing process of semiconductor device using a multilayer printed wiring board. In Examples 1 to 6 of the document, it is disclosed that the laminate having the above-mentioned configuration (double-sided copper-clad laminated sheet) has good low warpage before and after reflow treatment. The ratio of the storage modulus E' (180) at 180°C to the storage modulus E' (30) at 30°C (E' (180) /E' (30)) in

Examples 1 to 6 of the document is about 0.44 to 0.67. EP 2 947 122 A1 describes a resin composition comprising: nanoparticles (A) of alumina and/or boehmite having an average particle size from 1.0 nm or more to 100 nm or less; fine particles (B) having an average particle size from 0.20 μm or more to 100 μm or less; and a thermosetting resin (C), wherein the nanoparticles (A) have their surfaces treated with a polysiloxane-based modifier.
US 2015/0017450 A1 describes a resin composition, comprising (A) an epoxy resin having at least one chemical structure selected from naphthalene structure, biphenyl structure, and dicyclopentadiene structure; (B) an amine curing agent; (C) an accelerator having at least one functional group selected from dimethylureido group, imidazole group, and tertiary amino group; (D) silica particles; and (E) a silane coupling agent, wherein the epoxy resin (A) comprises 80 to 100% by mass of a bifunctional epoxy resin, and (D) is contained in an amount of 60 to 85% by mass based on 100% by mass of the total amount of the resin composition, the resin composition being substantially free of solvent and liquid at normal temperature.
US 2016/0108230 A1 describes a cyanate resin composition, comprising a cyanate resin (A), an epoxy resin (B) having a specific structure and a maleimide compound (C).

Citation List

Patent Literature

Patent Literature 1: Japanese Patent Laid-Open No. 2014-37485
Patent Literature 2: Japanese Patent Laid-Open No. 2016-40391
Patent Literature 3: Japanese Patent Laid-Open No. 2013-129827
Patent Literature 4: Japanese Patent Laid-Open No. 2017-193614
Patent Literature 5: Japanese Patent No. 5056787

Summary of Invention

Technical Problem

However, according to detailed studies by the present inventors, even with the above-described techniques in the related art, the warpage of a printed wiring board, particularly, a multilayer coreless substrate cannot be sufficiently reduced yet. In particular, the occurrence of warpage is more remarkable in a thin substrate such as a multilayer coreless substrate. For this reason, further improvement is desired in relation to reducing the warpage.
In view of the above, the present inventors diligently studied and found that in reducing the warpage of printed wiring boards, it is effective to reduce the elastic modulus of a cured product of a prepreg containing a resin composition (resin material) used for printed wiring boards to thereby develop viscous behavior. Therefore, the present inventors have studied the use of a resin material having a low elastic modulus and easily deforming plastically (having viscous behavior). However, when such a resin material is used, there arises another problem in that the handling property (handleability) in the manufacturing process of a printed wiring board (particularly a thin substrate such as a multilayer coreless substrate) is insufficient due to the low stiffness. Further, such a resin material tends to have a high water absorption rate and insufficient heat resistance and chemical resistance, and thus may cause a further problem from the viewpoint of quality.
Therefore, an object of the present invention is to provide a resin composition capable of sufficiently reducing the warpage of a printed wiring board and a multilayer printed wiring board (particularly, a multilayer coreless substrate) (achieving a low warpage) and exhibiting excellent stiffness and heat resistance, a prepreg, a laminate, a metal foil-clad laminate, a printed wiring board, and a multilayer printed wiring board (particularly, multilayer coreless substrate).

Solution to Problem

The present inventors have conducted intensive studies to solve the above problems, and as a result, it has been found that in the form of a cured product obtained by curing a prepreg, a resin composition having physical property parameters specified by a storage modulus at a predetermined temperature and a glass transition temperature that satisfy predetermined ranges can sufficiently reduce the warpage of a printed wiring board and a multilayer printed wiring board (particularly, a multilayer coreless substrate) and can exhibit excellent stiffness and heat resistance, thereby completing the present invention.
That is, the present invention is defined in the appended claims, and aspects thereof are as follows:
The present invention provides a resin composition comprising at least an organic resin, wherein the resin composition satisfies relationships represented by the following formulas (i), (ii), (iii), and (x):

$$0.80 \leq b/a \leq 0.95 \ldots \text{(i)};$$

$$0.40 \leq c/a \leq 0.65 \ldots \text{(ii)};$$

$$13 \leq a \leq 25 \ldots \text{(iii)};$$

and

$$175 \leq Tg \leq 215 \ldots \text{(x)},$$

wherein a, b, and c represent storage moduli at 40°C, 170°C, and 230°C, respectively, (unit: GPa) of a cured product obtained by curing a prepreg obtained by impregnating or coating a base material with the resin composition, and Tg represents a glass transition temperature (unit: °C) of the cured product,

wherein the organic resin comprises one or more selected from the group consisting of cyanate compounds and phenolic compounds, and two or more selected from the group consisting of epoxy compounds and maleimide compounds, and
wherein the storage moduli and glass transition temperature of the cured product are measured by a dynamic mechanical analysis method in accordance with JIS C6481
characterized in that the organic resin comprises two or more of the epoxy compounds, and the two or more epoxy compounds comprise a naphthalene-based epoxy resin comprising a naphthalene skeleton and an aralkyl-based epoxy resin.

In one embodiment, the resin composition further satisfies a relationship represented by the following formula (iv):

$$0.40 \leq d/a \leq 0.65 \ldots \text{(iv)},$$

wherein d represents a storage modulus at 260°C (unit: GPa) of a cured product obtained by curing a prepreg obtained by impregnating or coating a base material with the resin composition, and a is defined as above.

In one embodiment, the organic resin comprises one or more of the phenolic compounds and one or more selected from the group consisting of the epoxy compounds and the maleimide compounds.

In one embodiment, the resin composition further comprises a filler, wherein a content of the filler is 100 parts by mass or more and 700 parts by mass or less based on 100 parts by mass of a resin solid content in the resin composition.

In one embodiment, the filler comprises one or more inorganic fillers selected from the group consisting of silica, boehmite, and alumina.

In one embodiment, the filler comprises an inorganic filler and an organic filler.

In one embodiment, the resin composition is used for a metal foil-clad laminate.

In one embodiment, the resin composition is used for a printed wiring board.

In one embodiment, the resin composition is used for a multilayer printed wiring board.

The present invention further provides a prepreg comprising a base material and the resin composition according to the present invention with which the base material is impregnated or coated.

In one embodiment, in the prepreg, the base material is a glass base material.

In one embodiment, in the prepreg, the glass base material is made of a fiber of one or more glasses selected from the group consisting of E glass, D glass, S glass, T glass, Q glass, L glass, NE glass, and HME glass.

The present invention further provides a laminate comprising the prepreg according to the present invention.

The present invention further provides a metal foil-clad laminate comprising the prepreg according to the present invention and a metal foil disposed on one or both sides of the prepreg.

The present invention further provides a printed wiring board comprising an insulating layer formed of the prepreg according to the present invention and a conductor layer disposed on a surface of the insulating layer.

The present invention further provides a multilayer printed wiring board comprising a plurality of insulating layers comprising a first insulating layer and one or more second insulating layers laminated on one side of the first insulating layer, and a plurality of conductor layers comprising a first conductor layer disposed between adjacent two of the plurality of insulating layers and a second conductor layer disposed on a surface of an outermost layer of the plurality of insulating layers, in which each of the first insulating layer and the second insulating layer has a cured product of the prepreg according to the present invention.

Advantageous Effect of Invention

According to the present invention, it is possible to provide a resin composition capable of sufficiently reducing the warpage of a printed wiring board (particularly, a multilayer coreless substrate) (achieving a low warpage) and exhibiting excellent stiffness and heat resistance, and to provide a prepreg, a laminate, a metal foil-clad laminate, a printed wiring board, and a multilayer printed wiring board.

Brief Description of Drawings

[Figure 1] Figure 1 is a process flow diagram showing an exemplary procedure for manufacturing a panel of a multilayer coreless substrate (however, a method of manufacturing a multilayer coreless substrate is not limited to this, the same applies to Figures 2 to 8 below).
[Figure 2] Figure 2 is a process flow diagram showing an exemplary procedure for manufacturing the panel of the multilayer coreless substrate.
[Figure 3] Figure 3 is a process flow diagram showing an exemplary procedure for manufacturing the panel of the multilayer coreless substrate.
[Figure 4] Figure 4 is a process flow diagram showing an exemplary procedure for manufacturing the panel of the multilayer coreless substrate.
[Figure 5] Figure 5 is a process flow diagram showing an exemplary procedure for manufacturing the panel of the multilayer coreless substrate.
[Figure 6] Figure 6 is a process flow diagram showing an exemplary procedure for manufacturing the panel of the multilayer coreless substrate.
[Figure 7] Figure 7 is a process flow diagram showing an exemplary procedure for manufacturing the panel of the multilayer coreless substrate.
[Figure 8] Figure 8 is a process flow diagram showing an exemplary procedure for manufacturing the panel of the multilayer coreless substrate.
[Figure 9] Figure 9 is a partial cross-sectional view illustrating an exemplary configuration of the panel of the multilayer coreless substrate.

Description of Embodiment

A mode for carrying out the present invention (hereinafter referred to as "the present embodiment") will be described in detail below.

The term "resin solid content" as used herein refers to, unless otherwise specified, components excluding the solvent and the filler in the resin composition of the present embodiment, and 100 parts by mass of resin solid content means that the total amount of the components excluding the solvent and the filler in the resin composition is 100 parts by mass.

[Resin Composition]

A resin composition of the present embodiment comprises at least an organic resin and satisfies relationships represented by the following formulas (i), (ii), (iii), and (x):

$$0.80 \leq b/a \leq 0.95 \ldots (i);$$

$$0.40 \leq c/a \leq 0.65 \ldots (ii);$$

$$13 \leq a \leq 25 \ldots (iii);$$

and

$$175 \leq Tg \leq 215 \ldots (x).$$

In each formula, a, b, and c represent storage moduli at 40°C, 170°C, and 230°C, respectively, (unit: GPa) of a

cured product obtained by curing a prepreg obtained by impregnating or coating a base material with the resin composition of the present embodiment, and Tg represents a glass transition temperature (unit: °C) of the cured product.

With the above configuration, the resin composition of the present embodiment can sufficiently reduce the warpage of a metal foil-clad laminate, a printed wiring board, and a multilayer printed wiring board (particularly, a multilayer coreless substrate) and can exhibit excellent stiffness and heat resistance. This reason is considered as follows. Although the following description includes considerations, the present invention is not limited by the considerations.

Specifically, in reducing the warpage of a printed wiring board, it is important to reduce the elastic modulus of a cured product of a prepreg containing a resin composition (resin material) used for the printed wiring board and to develop viscous behavior. Accordingly, it is conceivable to use a resin material having a low elastic modulus and easily deforming plastically (exhibiting viscous behavior). However, when such a resin material is used, the handling property (handleability) in the manufacturing process of a printed wiring board (particularly a thin substrate such as a multilayer coreless substrate) becomes insufficient due to its low stiffness. Further, such a resin material tends to have a high water absorption rate and insufficient heat resistance and chemical resistance, and thus causes problems from the viewpoint of quality.

On the other hand, first, the resin composition of the present embodiment can ensure a sufficient stiffness in the form of a cured product obtained by curing a prepreg (also referred to as "cured form of prepreg") mainly due to the storage modulus at 40°C being within a predetermined range (the above relationship (iii) being satisfied), and can reduce the warpage of a metal foil-clad laminate, a printed wiring board, and a multilayer printed wiring board (particularly multilayer coreless substrate). The cured form of the prepreg maintains its stiffness sufficiently even when heated to 170°C mainly due to the ratio of the storage modulus at 170°C to the storage modulus at 40°C being within a predetermined range (the above relationship (i) being satisfied), and as a result, the resin composition of the present embodiment can impart the handling property (handleability) in the manufacturing process of a printed wiring board (particularly a thin substrate such as a multilayer coreless substrate). Viscous behavior can be exhibited during processes including heat treatment (for example, press molding process, annealing process) due to the ratio of the storage modulus at 230°C to the storage modulus at 40°C being within a predetermined range (the above relationship (ii) being satisfied), and as a result, the warpage of a metal foil-clad laminate, a printed wiring board, and a multilayer printed wiring board (particularly multilayer coreless substrate) can be reduced. Excellent heat resistance can be imparted to the metal foil-clad laminate, the printed wiring board, and the multilayer printed wiring body, mainly due to the storage modulus at 40°C being within a predetermined range (the above relationship (iii) being satisfied) and the glass transition temperature being within a predetermined range (the above relationship (X) being satisfied).

[Characteristics of resin composition]

As described above, the resin composition of the present embodiment provides a cured product obtained by curing a prepreg obtained by impregnating or coating a base material with the resin composition (hereinafter, also simply referred to as a "cured product" or a "prepreg cured product"), in which physical property parameters specified by a storage modulus at a predetermined temperature and a glass transition temperature satisfy their respective predetermined ranges.

$$0.80 \leq b/a \leq 0.95 \quad \ldots \text{ (i);}$$

$$0.40 \leq c/a \leq 0.65 \quad \ldots \text{ (ii);}$$

$$13 \leq a \leq 25 \quad \ldots \text{ (iii);}$$

and

$$175 \leq Tg \leq 215 \quad \ldots \text{ (x).}$$

In formula, a, b, and c represent storage moduli (unit: GPa) at 40°C, 170°C, and 230°C, respectively, of the cured product.

The prepreg may be a prepreg obtained by a known method. Specifically, the prepreg may be obtained by impregnating or coating a base material with the resin composition of the present embodiment, and then heating and drying at 100 to 200°C and thereby semi-curing (B-staging) the resin composition. The base material here may be a known base material used for various printed wiring board materials, and the impregnation or coating method may be a known method.

The cured product refers to a cured product obtained by thermally curing the prepreg at a heating temperature of 200 to 230°C and a heating time of 60 to 180 minutes. The pressure conditions for curing are not particularly limited as long as the effects of the present invention are not impaired, and usually, suitable conditions for curing the prepreg can be adopted, and the heating means for curing the prepreg is not particularly limited as long as the effects of the present invention are not impaired, and usual heating means (for example, a dryer) may be used.

The storage modulus and glass transition temperature of the cured product may be measured by a dynamic mechanical analysis method (DMA method) in accordance with JIS C6481. As a more detailed measurement method, first, copper foil (3EC-VLP, product of Mitsui Mining & Smelting Co., Ltd., thickness 12 μm) is disposed on the upper and lower surfaces of one prepreg, and lamination molding (thermal curing) is performed at a pressure of 30 kgf/cm$^2$ and a temperature of 230°C for 100 minutes to obtain a copper foil-clad laminate having a predetermined thickness. Subsequently, the obtained copper foil-clad laminate is cut into a size of 5.0 mm × 20 mm with a dicing saw, and the copper foil on the surface is removed by etching to obtain a sample for measurement. The storage modulus and the glass transition temperature of the obtained sample for measurement are measured using a dynamic viscoelasticity analyzer (TA Instruments product). The measurement value is obtained, for example, as an arithmetic mean of three measured values.

The stiffness can be sufficiently ensured due to a (storage modulus at 40°C) in formula (iii) being 13 GPa or more. From the same viewpoint, a is preferably 15 GPa or more, and more preferably 16 GPa or more. On the other hand, the warpage of a metal foil-clad laminate, a printed wiring board (and a multilayer printed wiring board (particularly, a multilayer coreless substrate)) can be reduced due to a being 25 GPa or less. From the same viewpoint, a is preferably 23 GPa or less, and more preferably 20 GPa or less.

The stiffness is sufficiently maintained even when heated to 170°C, due to b/a (the ratio of the storage modulus at 170°C to the storage modulus at 40°C) in formula (i) being 0.80 or more, and as a result, the resin composition of the present embodiment is excellent in the handling property (handleability) in, for example, a manufacturing process of a printed wiring board (particularly a thin substrate such as a multilayer coreless substrate). From the same viewpoint, b/a is preferably 0.81 or more, and more preferably 0.82 or more. Incidentally, b/a is preferably 0.92 or less, and more preferably 0.90 or less.

Viscous behavior can be exhibited during processes including heat treatment (for example, press molding process, annealing process) due to c/a (the ratio of the storage modulus at 230°C to the storage modulus at 40°C) in formula (ii) being within the above predetermined range, and as a result, the warpage of a metal foil-clad laminate, a printed wiring board, and a multilayer printed wiring board (particularly multilayer coreless substrate) can be reduced. The lower limit value of c/a is preferably 0.42, more preferably 0.44, from the viewpoint of further improving the handling property (handleability) in the manufacturing process of a printed wiring board (particularly a thin substrate such as a multilayer coreless substrate), and the upper limit value of c/a is preferably 0.63, more preferably 0.61 from the viewpoint of further reducing the warpage of a metal foil-clad laminate, a printed wiring board, and a multilayer printed wiring board (particularly, the multilayer coreless board).

The resin composition of the present embodiment can improve the heat resistance due to the glass transition temperature of the cured product satisfying formula (x). From the same viewpoint, the glass transition temperature is preferably 178°C or higher, preferably 180°C or higher, more preferably 185°C or higher, and still more preferably 190°C or higher.

It is preferable that the resin composition of the present embodiment further satisfy the relationship represented by formula (iv):

$$0.40 \le d/a \le 0.65 \quad \ldots \text{(iv)}$$

In formula, d represents a storage modulus at 260°C (unit: GPa) of a cured product obtained by curing a prepreg obtained by impregnating or coating a base material with the resin composition of the present embodiment.

When the relationship represented by formula (iv) is satisfied, the resin composition of the present embodiment tends to be more excellent in the heat resistance of the cured product to be obtained, which tends to exhibit sufficient heat resistance even when exposed to a high temperature of 300°C, for example, and furthermore, tends to have a further improved handling property in a packaging process for packaging a semiconductor chip on a printed wiring board (in particular, a multilayer coreless substrate). From the same viewpoint, the lower limit value of d/a is preferably 0.41 or more, and more preferably 0.42 or more.

[Constituents]

The resin composition of the present embodiment contains at least an organic resin as a constituent, and may further contain an inorganic filler, a silane coupling agent, a wetting and dispersing agent, and a curing accelerator.

(Organic resin)

Examples of organic resins include, but not particularly limited to, cyanate compounds, phenolic compounds, epoxy compounds, and maleimide compounds. These organic resins may be used singly or in combinations of two or more. Among these, the organic resin, from the viewpoint of further improving the glass transition temperature, chemical resistance, and peel strength of the cured product to be obtained, contains two or more (preferably three or more) selected from the group consisting of the epoxy compounds and the maleimide compounds. From the same viewpoint, the organic resin contains one or more selected from the group consisting of the cyanate compounds and the phenolic compounds and two or more selected from the group consisting of the epoxy compounds and the maleimide compounds, and more preferably one or more of the phenolic compounds and two or more selected from the group consisting of the epoxy resins and the maleimide compounds.

(Cyanate compound)

The organic resin of the present embodiment may contain a cyanate compound. As used herein, the term "cyanate compound" refers to a compound having two or more cyanate groups (cyanate groups) in one molecule, and the term "compound" refers to a concept encompassing a resin. The cyanate compound is not particularly limited as long as it is a compound having two or more cyanate groups (cyanate groups) in one molecule, but examples thereof include aromatic hydrocarbon compounds containing two or more cyanate groups in one molecule, compounds containing two or more cyanate groups in which two aromatic rings are bonded by a linking group, novolac-based cyanates, bisphenol-based cyanates, diallyl bisphenol-based cyanates (for example, diallyl bisphenol A-based cyanate, diallyl bisphenol E-based cyanate, diallyl bisphenol F-based cyanate, diallyl bisphenol S-based cyanate), aralkyl-based cyanates, and prepolymers of these cyanates. The cyanate compounds may be used singly or in combinations of two or more.

Examples of aromatic hydrocarbon compounds having two or more cyanate groups in one molecule include a compound represented by formula (I): $Ar\text{-}(OCN)_p$, wherein Ar represents any one of a benzene ring, a naphthalene ring, and a biphenyl ring, and p represents an integer of 2 or more. Examples of compounds represented by formula (I) include, but not particularly limited to, 1,3-dicyanatebenzene, 1,4-dicyanatebenzene, 1,3,5-tricyanatebenzene, 1,3-dicyanatenaphthalene, 1,4-dicyanatenaphthalene, 1,6-dicyanatenaphthalene, 1,8-dicyanatenaphthalene, 2,6-dicyanatenaphthalene, 2,7-dicyanatenaphthalene, 1,3,6-tricinatonaphthalene, and 4,4'-dicyanatebiphenyl.

Examples of compounds containing two or more cyanate groups in which two aromatic rings are bonded by a linking group include, but not particularly limited to, bis(4-cyanatephenyl)ether, bis(4-cyanatephenyl)thioether, and bis(4-cyanatephenyl)sulfone.

Examples of novolac-based cyanates include a compound represented by the following formula (1):

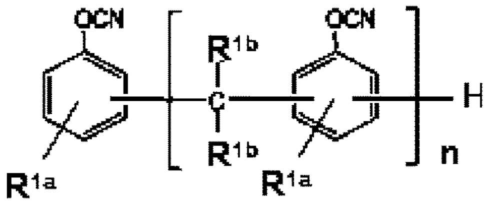

(1)

In formula (1), each $R^{1a}$ independently represents a hydrogen atom or an alkyl group having 1 to 5 carbon atoms, each $R^{1b}$ independently represents a hydrogen atom or a methyl group (preferably a hydrogen atom), and n represents an integer of 1 to 10 (preferably an integer of 1 to 7).

Examples of compounds represented by formula (1) include, but not particularly limited to, bis(3,5-dimethyl4-cyanatephenyl)methane, bis(4-cyanatephenyl)methane, and 2,2'-bis(4-cyanatephenyl)propane.

These cyanate compounds may be used singly or in combinations of two or more. Among these, the cyanate compound is preferably a bisphenol-based cyanate and/or an aralkyl-based cyanate from the viewpoint of further improving the heat resistance and low water absorption of the cured product to be obtained.

(Bisphenol-based cyanate)

Examples of bisphenol-based cyanates include, but not particularly limited to, bisphenol A-based cyanates, bisphenol E-based cyanates, bisphenol F-based cyanates, and bisphenol S-based cyanates.

As the bisphenol-based cyanate, a commercially available product may be used, or a preparation prepared by a known method may be used. Examples of commercially available bisphenol-based cyanates include "CA210" manufactured by Mitsubishi Gas Chemical Company, Ltd.

(Aralkyl-based cyanate)

Examples of aralkyl-based cyanates include, but not particularly limited to, naphthol aralkyl-based cyanates and biphenyl aralkyl-based cyanates.

Examples of naphthol aralkyl-based cyanates include a compound represented by the following formula (1a):

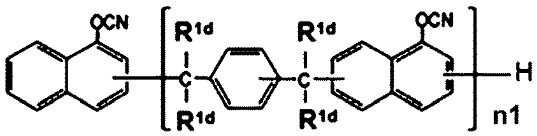

(1a)

In formula (1a), each $R^{1d}$ independently represents a hydrogen atom or a methyl group (preferably a hydrogen atom), and n1 represents an integer of 1 to 10 (preferably an integer of 1 to 6).

Examples of biphenyl aralkyl-based cyanates include a compound represented by the following formula (1b):

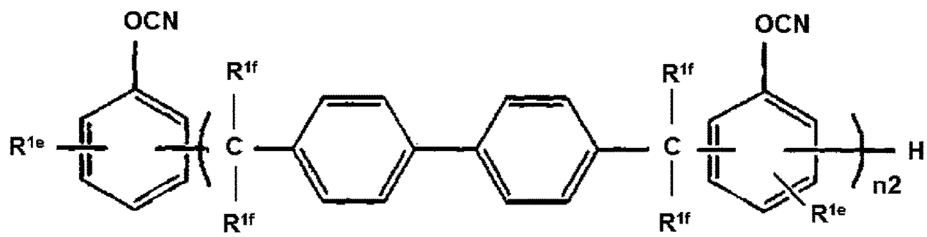

(1b)

In formula (1b), each $R^{1e}$ independently represents a hydrogen atom or an alkyl group having 1 to 5 carbon atoms, and each $R^{1f}$ independently represents a hydrogen atom or a methyl group (preferably a hydrogen atom), and n2 represents an integer of 1 to 10 (preferably an integer of 1 to 6).

As the aralkyl-based cyanate, a commercially available product may be used, or a product synthesized by a known method may be used. Examples of a method for synthesizing the aralkyl-based cyanate include a method of reacting a phenolic resin corresponding to a target aralkyl-based cyanate (hereinafter, also referred to as "corresponding phenolic resin"), a cyanogen halide, and a basic compound in an inert organic solvent, and a method of subjecting a salt formed by reacting a corresponding phenolic resin and a basic compound in an aqueous solution and a cyanogen halide to a two-phase interfacial reaction. In any of the methods, the aralkyl-based cyanate may be obtained by cyanating a hydrogen atom of the phenolic hydroxyl group of the corresponding phenolic resin. More specifically, for example, methods described in the Examples section may be used.

The content of the cyanate compound is not particularly limited, but is preferably 10 parts by mass or more and 45 parts by mass or less based on 100 parts by mass of the resin solid content. When the content is within the above range, the storage modulus at the time of heating tends to be a value suitable for suppressing warpage, and the warpage of a metal foil-clad laminate, a printed wiring board, and a multilayer printed wiring board (particularly, the multilayer coreless substrate) tends to be further reduced. From the same viewpoint, the lower limit value of the content is preferably 10 parts by mass, more preferably 15 parts by mass, and still more preferably 20 parts by mass, and the upper limit value of the content is preferably 45 parts by mass, more preferably 40 parts by mass, and still more preferably 35 parts by mass.

The cyanate equivalent of the cyanate compound is preferably 100 to 500 g/eq, more preferably 400 g/eq or less, and still more preferably 300 g/eq or less. When the cyanate equivalent is within the above range, the cured product to be obtained is further improved in stiffness, and the glass transition temperature and the storage modulus at the time of heating tend to be values suitable for suppressing warpage.

(Phenolic compound)

The organic resin of the present embodiment may contain a phenolic compound. As used herein, the term "phenolic compound" refers to a compound having two or more phenolic hydroxyl groups in one molecule, and the term "compound" refers to a concept encompassing a resin. The phenolic compound is not particularly limited as long as it is a compound having two or more phenolic hydroxyl groups in one molecule, but examples thereof include phenols having two or more phenolic hydroxyl groups in one molecule, bisphenols (for example, bisphenol A, bisphenol E, bisphenol F,

bisphenol S), diallyl bisphenols (for example, diallyl bisphenol A, diallyl bisphenol E, diallyl bisphenol F, diallyl bisphenol S), bisphenol-based phenolic resins (for example, bisphenol A-based resin, bisphenol E-based resin, bisphenol F-based resin, bisphenol S-based resin), phenolic novolac resins (for example, phenol novolac resin, naphthol novolac resin, cresol novolac resin), glycidyl ester-based phenolic resins, naphthalene-based phenolic resins, anthracene-based phenolic resins, dicyclopentadiene-based phenolic resins, biphenyl-based phenolic resins, alicyclic phenolic resins, polyol-based phenolic resins, aralkyl-based phenolic resins, and phenol-modified aromatic hydrocarbon formaldehyde resins. These phenolic compounds may be used singly or in combinations of two or more. Among these, the phenolic compound is preferably an aralkyl-based phenolic resin and/or a phenol-modified aromatic hydrocarbon formaldehyde resin from the viewpoint of further improving the heat resistance and low water absorption of the cured product to be obtained.

(Aralkyl-based phenolic resin)

Examples of aralkyl-based phenolic resins include a compound represented by the following formula (2a):

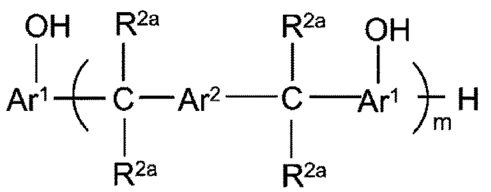

(2a)

In formula (2a), each $Ar^1$ independently represents a benzene ring or a naphthalene ring, $Ar^2$ represents a benzene ring, a naphthalene ring, or a biphenyl ring, and each $R^{2a}$ independently represents a hydrogen atom or a methyl group, m represents an integer of 1 to 50, and each ring may have a substituent other than a hydroxyl group (for example, an alkyl group having 1 to 5 carbon atoms or a phenyl group).

From the viewpoint of further improving the heat resistance and low water absorption of the cured product to be obtained, the compound represented by formula (2a) is preferably a compound in which $Ar^1$ is a naphthalene ring and $Ar^2$ is a benzene ring in formula (2a) (also referred to as "naphthol aralkyl-based phenolic resin") and a compound in which $Ar^1$ is a benzene ring and $Ar^2$ is a biphenyl ring in formula (2a) (also referred to as "biphenyl aralkyl-based phenolic resin").

The naphthol aralkyl-based phenolic resin is preferably a compound represented by the following formula (2b):

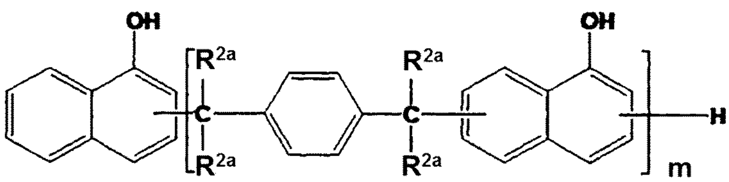

(2b)

In formula (2b), each $R^{2a}$ independently represents a hydrogen atom or a methyl group (preferably a hydrogen atom), and m represents an integer of 1 to 10 (preferably an integer of 1 to 6).

The biphenyl aralkyl-based phenolic resin is preferably a compound represented by the following formula (2c):

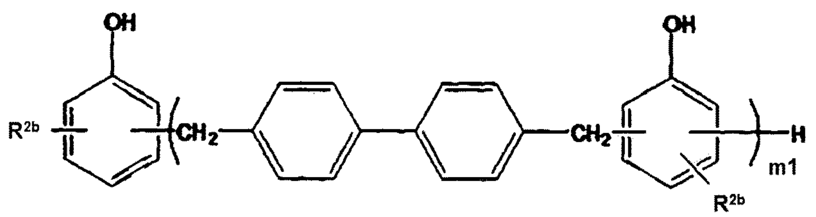

(2c)

In formula (2c), each $R^{2b}$ independently represents a hydrogen atom, an alkyl group having 1 to 5 carbon atoms, or a phenyl group (preferably a hydrogen atom), and m1 is an integer of 1 to 20 (preferably an integer of 1 to 6).

As the aralkyl-based phenolic resin, a commercially available product may be used, or a product synthesized by a known method may be used. Examples of commercially available aralkyl-based phenolic resins include "KAYAHARD GPH-65", "KAYAHARD GPH-78", and "KAYAHARD GPH-103" manufactured by Nippon Kayaku Co., Ltd. (all biphenyl aralkyl-based phenolic resin represented by formula (2c)) and "SN-495" (a naphthol aralkyl-based phenolic resin

represented by formula (2b)) manufactured by Nippon Steel Chemical & Material Co., Ltd.

(Phenol-modified aromatic hydrocarbon formaldehyde resin)

As used herein, the term "phenol-modified aromatic hydrocarbon formaldehyde resin" refers to a resin obtained by heating an aromatic hydrocarbon formaldehyde resin and a phenol in the presence of an acidic catalyst (for example, paratoluenesulfonic acid, oxalic acid) to cause a condensation reaction (modification condensation reaction).

Examples of aromatic hydrocarbon formaldehyde resins include, but not particularly limited to, a compound obtained by subjecting an aromatic hydrocarbon compound (for example, toluene, ethylbenzene, xylene, mesitylene, pseudocumene, monocyclic aromatic hydrocarbon compounds having 10 or more carbon atoms, polycyclic aromatic hydrocarbon compounds such as methylnaphthalene) and formaldehyde to a condensation reaction. Among these, a xylene formaldehyde resin obtained by subjecting xylene and formaldehyde to a condensation reaction is preferred.

Examples of phenols include, but not particularly limited to, phenol, cresols, bisphenolpropane, bisphenolmethane, resorcin, pyrocatechol, hydroquinone, p-tert-butylphenol, bisphenolsulfone, bisphenolether, and p-phenylphenol. These phenols may be used singly or in combinations of two or more.

The phenol-modified aromatic hydrocarbon formaldehyde resin is preferably a phenol-modified xylene formaldehyde resin obtained by heating a xylene formaldehyde resin and the above described phenol in the presence of the above described acidic catalyst to cause a condensation reaction.

As the phenol-modified aromatic hydrocarbon formaldehyde resin, a commercially available product may be used, or a preparation prepared by a known method may be used. Examples of commercially available phenol-modified aromatic hydrocarbon formaldehyde resins include "HP-120", "HP-100", "HP-210", "HP-70", "NP-100", "GP-212", "P-100", "GP-100", "GP-200", and "HP-30" manufactured by Fudow Co., Ltd. Examples of known methods include the method disclosed in Japanese Patent Application Laid-Open No. 2015-174874.

The content of the phenolic compound is not particularly limited, but is preferably 10 parts by mass or more and 60 parts by mass or less based on 100 parts by mass of the resin solid content. When the content is within the above range, the storage modulus at the time of heating tends to be a value suitable for suppressing warpage, and the warpage of a metal foil-clad laminate, a printed wiring board, and a multilayer printed wiring board (particularly, the multilayer coreless substrate) tends to be further reduced. From the same viewpoint, the lower limit of the content is preferably 10 parts by mass, more preferably 20 parts by mass, and still more preferably 30 parts by mass, and the upper limit value of the content is preferably 60 parts by mass, more preferably 55 parts by mass, still more preferably 50 parts by mass, and particularly preferably 40 parts by mass.

The phenol equivalent of the phenolic compound (the hydroxyl group equivalent of the phenolic hydroxyl group) is preferably 500 g/eq or less (for example, 100 to 500 g/eq), more preferably 400 g/eq or less, still more preferably 350 g/eq or less, and particularly preferably 300 g/eq or less. When the phenol equivalent is within the above range, the cured product to be obtained is further improved in stiffness, and the glass transition temperature and the storage modulus at the time of heating tend to be values suitable for suppressing warpage.

(Epoxy compound)

The organic resin of the present embodiment contains two or more of epoxy compounds, and the two or more epoxy compounds comprise a naphthalene-based epoxy resin comprising a naphthalene skeleton and an aralkyl-based epoxy resin. As used herein, the term "epoxy compound" refers to a compound having two or more epoxy groups in one molecule, and the term "compound" refers to a concept encompassing a resin. The epoxy compound is not particularly limited as long as it is a compound having two or more epoxy groups in one molecule, but examples thereof include bisphenol-based epoxy resins (for example, bisphenol A-based epoxy resin, bisphenol E-based epoxy resin, bisphenol F-based epoxy resin, bisphenol S-based epoxy resin), diallyl bisphenol-based epoxy resins (for example, diallyl bisphenol A-based epoxy resin, diallyl bisphenol E-based epoxy resin, diallyl bisphenol F-based epoxy resin, diallyl bisphenol S-based epoxy resin), phenolic novolac-based epoxy resins (for example, phenol novolac-based epoxy resin, bisphenol A novolac-based epoxy resin, cresol novolac-based epoxy resin), aralkyl-based epoxy resins, biphenyl-based epoxy resins containing a biphenyl skeleton, naphthalene-based epoxy resins containing a naphthalene skeleton, anthracene-based epoxy resins containing an anthracene skeleton, glycidyl ester-based epoxy resins, polyol-based epoxy resins, epoxy resins containing an isocyanurate ring, dicyclopentadiene-based epoxy resins, epoxy resins including a bisphenol A-based structural unit and a hydrocarbon-based structural unit, and halogen compounds thereof. These epoxy compounds may be used singly or in combinations of two or more. Among them, one or more selected from the group consisting of aralkyl-based epoxy resins, naphthalene-based epoxy resins, dicyclopentadiene-based epoxy resins, and epoxy resins including a bisphenol A-based structural unit and a hydrocarbon-based structural unit are preferred from the viewpoint of further improving the heat resistance and low water absorption of the cured product to be obtained. From the viewpoint of setting the storage modulus at the time of heating to a value more suitable for suppressing warpage, the organic resin of the

present embodiment contains two or more epoxy compounds, and the two or more epoxy compounds contain a naphthalene-based epoxy resin containing a naphthalene-based epoxy resin and an aralkyl-based epoxy resin (particularly biphenyl aralkyl-based epoxy resin).

(Aralkyl-based epoxy resin)

Examples of aralkyl-based epoxy resins include a compound represented by the following formula (3a):

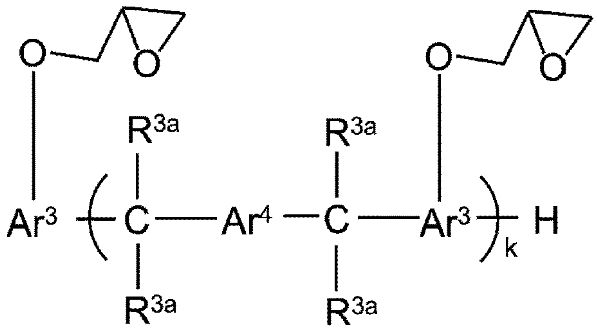

(3a)

In formula (3a), each $Ar^3$ independently represents a benzene ring or a naphthalene ring, $Ar^4$ represents a benzene ring, a naphthalene ring, or a biphenyl ring, and each $R^{3a}$ independently represents a hydrogen atom or a methyl group, k represents an integer of 1 to 50, and each ring may have a substituent other than a glycidyloxy group (for example, an alkyl group having 1 to 5 carbon atoms or a phenyl group).

From the viewpoint of further improving the heat resistance and low water absorption of the cured product to be obtained, the compound represented by formula (3a) is preferably a compound in which $Ar^3$ is a naphthalene ring and $Ar^4$ is a benzene ring in formula (3a) (also referred to as "naphthalene aralkyl-based epoxy resin") or a compound in which $Ar^3$ is a benzene ring and $Ar^4$ is a biphenyl ring (also referred to as "biphenyl aralkyl-based epoxy resin"), and more preferably a biphenyl aralkyl-based epoxy resin.

As the aralkyl-based epoxy resin, a commercially available product may be used, or a preparation prepared by a known method may be used. Examples of commercially available naphthalene aralkyl-based epoxy resins include "EPOTOHTO (R) ESN-155", "EPOTOHTO (R) ESN-355", "EPOTOHTO (R) ESN-375", " EPOTOHTO (R) ESN-475V", "EPOTOHTO (R) ESN-485", and "EPOTOHTO (R) ESN-175" manufactured by Nippon Steel & Sumitomo Metal Corporation, "NC-7000", "NC-7300", and "NC-7300L" manufactured by Nippon Kayaku Co., Ltd., and "HP-5000", "HP-9900", "HP-9540", and "HP-9500 "manufactured by DIC Corporation. Examples of commercially available biphenyl aralkyl-based epoxy resins include "NC-3000", "NC-3000L", and "NC-3000FH" manufactured by Nippon Kayaku Co., Ltd.

The biphenyl aralkyl-based epoxy resin is preferably a compound represented by the following formula (3b), from the viewpoint of further improving the heat resistance and low water absorption of the cured product to be obtained.

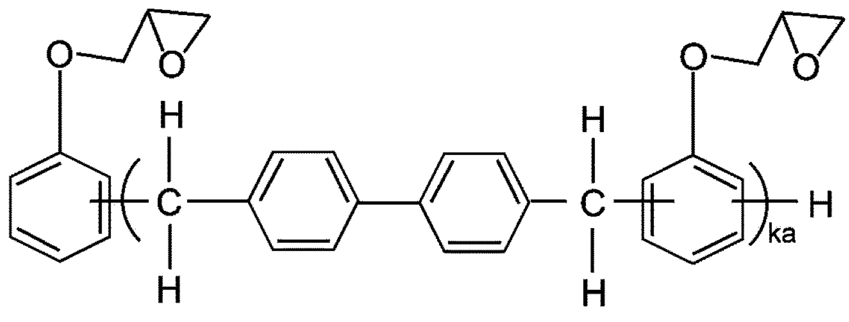

(3b)

In formula (3b), ka represents an integer of 1 or more, preferably 1 to 20, and more preferably 1 to 6.

The aralkyl-based epoxy resin may be a compound represented by the following formula (3-a):

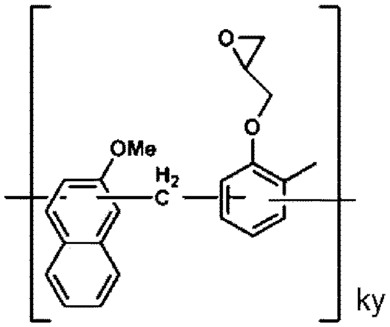

(3 − a)

In formula (3-a), ky represents an integer of 1 to 10.

(Naphthalene-based epoxy resin)

Examples of naphthalene-based epoxy resins include, but not particularly limited to, epoxy resins other than the above naphthalene aralkyl-based epoxy resin, including naphthalene skeleton-containing polyfunctional epoxy resins having a naphthalene skeleton represented by the following formula (3-1) and epoxy resins having a naphthalene skeleton (for example, epoxy resins represented by the following formula (3c-1)). Specific Examples of naphthalene-based epoxy resins include naphthylene ether-based epoxy resins, and from the viewpoint of further improving the heat resistance and low water absorption of the cured product to be obtained, naphthylene ether-based epoxy resins are preferred.

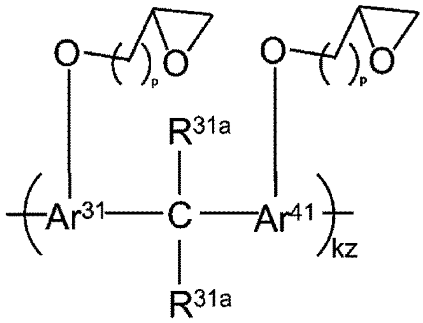

(3 − 1)

In formula (3-1), each $Ar^{31}$ independently represents a benzene ring or a naphthalene ring, $Ar^{41}$ represents a benzene ring, a naphthalene ring, or a biphenyl ring, each $R^{31a}$ independently represents a hydrogen atom or a methyl group, p represents an integer of 0 to 2 (preferably an integer of 0 or 1), kz represents an integer of 1 to 50, each ring may have a substituent other than glycidyloxy group (for example, an alkyl group having 1 to 5 carbon atoms, an alkoxy group, or a phenyl group), and at least one of $Ar^{31}$ and $Ar^{41}$ represents a naphthalene ring.

Examples of compounds represented by formula (3-1) include a compound represented by formula (3b):

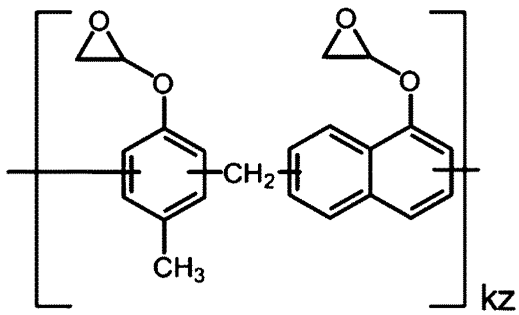

(3 b)

In formula (3b), kz has the same meaning as kz in formula (3-1).

As the naphthalene skeleton-containing polyfunctional epoxy resin, a commercially available product may be used, or a preparation prepared by a known method may be used. Examples of commercially available naphthalene

skeleton-containing polyfunctional epoxy resins include "HP-9540" and "HP-9500" manufactured by DIC Corporation.

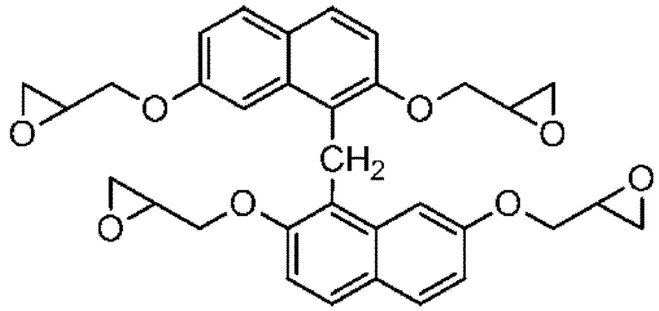

(3c-1)

As the epoxy resin represented by formula (3c-1), a commercially available product may be used, or a preparation prepared by a known method may be used. Examples of commercially available products thereof include "HP-4710" manufactured by DIC Corporation.

(Naphthylene ether-based epoxy resin)

Examples of naphthylene ether-based epoxy resins include a compound represented by the following formula (3c):

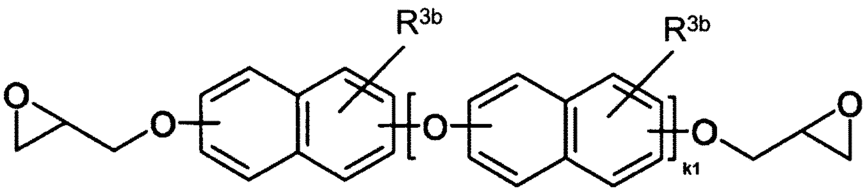

(3c)

In formula (3c), each $R^{3b}$ independently represents a hydrogen atom, an alkyl group having 1 to 5 carbon atoms, an aralkyl group, a naphthyl group, or a naphthyl group containing a glycidyloxy group, and k1 represents an integer of 1 to 10.

In the compound represented by formula (3c), the number of epoxy group-containing glycidyloxy groups in the molecule is preferably from 2 to 6, and more preferably from 2 to 4.

In formula (3c), k1 represents an integer of 0 to 10, and from the viewpoint of more effectively and reliably achieving the effects of the present invention, preferably represents an integer of 0 to 6, more preferably an integer of 0 to 4, and still more preferably 2 to 3.

In formula (3c), each $R^{3b}$ independently and preferably represents a hydrogen atom, an alkyl group having 1 to 5 carbon atoms, an aralkyl group, or a naphthyl group, from the viewpoint of more effectively and reliably achieving the effects of the present invention.

When the naphthylene ether-based epoxy resin contains the compound represented by formula (3c), a plurality of compounds having the same k1 may be contained or a plurality of compounds having different k1 may be contained. When the naphthylene ether-based epoxy resin contains a plurality of compounds having different k1, it is preferable to contain compounds in which k1 is 0 to 4 in formula (3c), and more preferable to contain a compound in which k1 is 2 to 3.

Examples of compounds represented by formula (3c) include a compound represented by formula (3c-2):

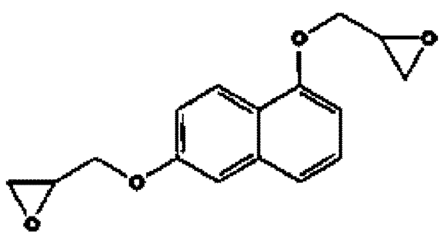

(3c-2)

As the epoxy resin represented by formula (3c-2), a commercially available product may be used, or a

preparation prepared by a known method may be used. Examples of commercially available products thereof include "HP-4032" manufactured by DIC Corporation.

As the naphthylene ether-based epoxy resin, a commercially available product may be used, or a preparation prepared by a known method may be used. Examples of commercially available naphthylene ether-based epoxy resins include "HP-4032", "HP-6000", "EXA-7300", "EXA-7310", "EXA-7311", "EXA-7311L", and "EXA7311-G3" manufactured by DIC Corporation.

(Dicyclopentadiene-based epoxy resin)

Examples of dicyclopentadiene-based epoxy resins include a compound represented by the following formula (3d) :

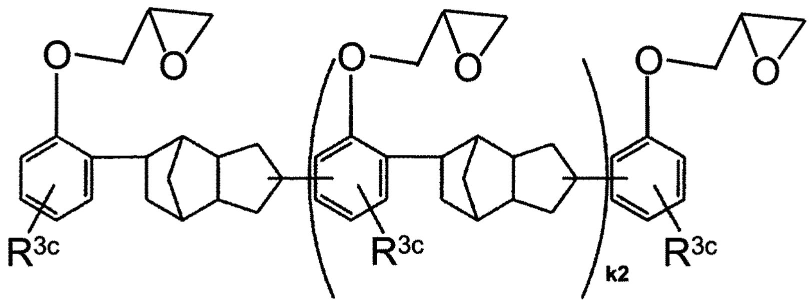

(3 d)

In formula (3d), each $R^{3c}$ independently represents a hydrogen atom or an alkyl group having 1 to 5 carbon atoms, and k2 represents an integer of 0 to 10.

In formula (3d), k2 represents an integer of 0 to 10, and from the viewpoint of more effectively and reliably achieving the effects of the present invention, preferably represents an integer of 0 to 6, and preferably an integer of 0 to 2 (preferably 0 or 1).

When the dicyclopentadiene-based epoxy resin contains the compound represented by formula (3d), a plurality of compounds having the same k2 may be contained or a plurality of compounds having different k2 may be contained. When the dicyclopentadiene-based epoxy resin contains a plurality of compounds having different k2, it is preferable to contain compounds in which k2 is 0 to 2 in formula (3c).

As the dicyclopentadiene-based epoxy resin, a commercially available product may be used, or a preparation prepared by a known method may be used. Examples of commercially available dicyclopentadiene-based epoxy resins include "EPICRON HP-7200L", "EPICRON HP-7200", "EPICRON HP-7200H", and "EPICRON HP-7000HH" manufactured by Dainippon Ink and Chemicals, Inc.

(Epoxy resin including bisphenol A-based structural unit and hydrocarbon-based structural unit)

The epoxy resin including a bisphenol A-based structural unit and a hydrocarbon structural unit (also referred to as a "specific epoxy resin") has one or more bisphenol A-based structural units and one or more hydrocarbon-based structural units in a molecule. Examples of specific epoxy resins include a compound represented by the following formula (3e):

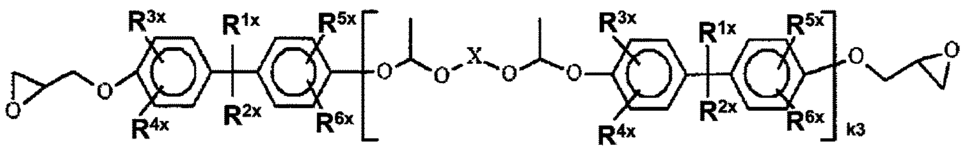

(3 e)

In formula (3e), each $R^{1x}$ and $R^{2x}$ independently represent a hydrogen atom or a methyl group, and each $R^{3x}$ to $R^{6x}$ independently represent a hydrogen atom, a methyl group, a chlorine atom, or a bromine atom, X represents an ethyleneoxyethyl group, a di(ethyleneoxy)ethyl group, a tri(ethyleneoxy)ethyl group, a propyleneoxypropyl group, a di(propyleneoxy)propyl group, a tri(propyleneoxy)propyl group, or an alkylene group having 2 to 15 carbon atoms, and k3 represents a natural number.

In formula (3e), k3 represents a natural number, and from the viewpoint of more effectively and reliably achieving the effects of the present invention, preferably is a natural number of 1 to 10, more preferably a natural number of 1 to 6, still

more preferably a natural number of 1 or 2, and particularly preferably 1.

In formula (3e), X is preferably an ethylene group from the viewpoint of more effectively and reliably achieving the effects of the present invention.

As the specific epoxy resin, a commercially available product may be used, or a preparation prepared by a known method may be used. Examples of commercially available specific epoxy resins include "EPICLON EXA-4850-150" and "EPICLON EXA-4816" manufactured by DIC Corporation.

The content of the epoxy compound is not particularly limited, but is preferably 10 parts by mass or more and 80 parts by mass or less based on 100 parts by mass of the resin solid content. When the content is within the above range, the storage modulus at the time of heating tends to be a value suitable for suppressing warpage, and the warpage of a metal foil-clad laminate, a printed wiring board, and a multilayer printed wiring board (particularly, the multilayer coreless substrate) tends to be further reduced. When the content is within the above range, the stiffness, heat resistance and low water absorption of the cured product to be obtained tend to be further improved. From the same viewpoint, the lower limit of the content is preferably 10 parts by mass, more preferably 20 parts by mass, still more preferably 30 parts by mass, and particularly preferably 40 parts by mass, and the upper limit of the content is preferably 80 parts by mass, more preferably 75 parts by mass, and still more preferably 70 parts by mass.

The epoxy equivalent of the epoxy compound is preferably 100 to 500 g/eq or less, more preferably 400 g/eq or less, and still more preferably 350 g/eq or less. When the epoxy equivalent is within the above range, the cured product to be obtained is further improved in stiffness, and the glass transition temperature and the storage modulus at the time of heating tend to be values suitable for suppressing warpage.

When the resin composition contains the phenolic compound and/or the cyanate compound and the epoxy compound, the ratio of the amount of phenol groups (content parts by mass/phenol equivalent) and/or the amount of cyanate groups (content parts by mass/cyanate equivalent) in the resin composition to the amount of epoxy groups (content parts by mass/epoxy equivalent) in the resin composition is preferably 0.5 to 1.5. When the resin composition contains both the phenolic compound and the cyanate compound, the above ratio is the ratio of the total amount of the amount of phenol groups and the amount of cyanate groups to the amount of epoxy groups. When the ratio is within the above range, the storage modulus at the time of heating tends to be a value suitable for suppressing warpage. From the same viewpoint, the lower limit value of the ratio is preferably 0.5, more preferably 0.6, still more preferably 0.7, and particularly preferably 0.9, and the upper limit value of the ratio is preferably 1.5, more preferably 1.4, still more preferably 1.3, and particularly preferably 1.2. When there are a plurality of phenolic compounds, the above-mentioned amount of phenol groups refers to the total value of the respective amounts of phenol groups of the phenolic compounds; when there are a plurality of cyanate compounds, the above-mentioned amount of cyanate groups refers to the total value of the respective amounts of cyanate groups of the cyanate compounds; and when there are a plurality of epoxy compounds, the above-mentioned amount of epoxy groups refers to the total value of the respective amounts of epoxy groups of the epoxy compounds.

(Maleimide compound)

The organic resin of the present embodiment may contain a maleimide compound. As used herein, the term "maleimide compound" refers to a compound having one or more maleimide groups in one molecule, and the term "compound" refers to a concept encompassing a resin. The maleimide compound is not particularly limited as long as it has one or more maleimide groups in one molecule, but examples thereof include monomaleimide compounds having one maleimide group in one molecule (for example, N-phenylmaleimide, N-hydroxyphenylmaleimide), polymaleimide compounds having two or more maleimide groups in one molecule (for example, bis(4-maleimidophenyl)methane, bis(3,5-dimethyl-4-maleimidophenyl)methane, bis(3-ethyl-5-methyl-4-maleimidophenyl)methane, bis(3,5-diethyl-4-maleimidophenyl)methane, and prepolymers of these maleimide compounds and amine compounds. These maleimide compounds may be used singly or in combinations of two or more. Among these, the maleimide compound is preferably a polymaleimide compound from the viewpoint of further improving the heat resistance and glass transition temperature of the cured product to be obtained.

Examples of polymaleimide compounds include compounds in which a plurality of maleimide groups are bonded to a benzene ring (for example, phenylenebismaleimide such as m-phenylenebismaleimide, 4-methyl-1,3-phenylenebismaleimide), compounds in which a maleimide group is bonded to both ends of a linear or branched alkyl chain (for example, 1,6-bismaleimide-(2,2,4-trimethyl)hexane), bisphenol A diphenyl ether bismaleimide, and a compound represented by the following formula (4a):

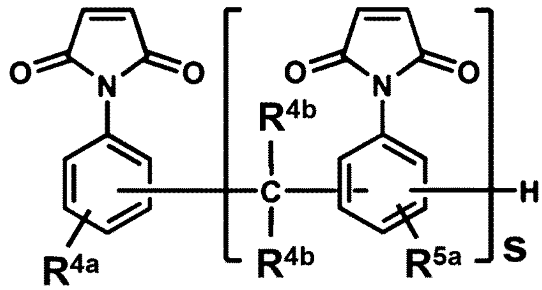

(4 a)

In formula, each $R^{4a}$ and $R^{5a}$ independently represent a hydrogen atom or an alkyl group having 1 to 5 carbon atoms, and preferably a hydrogen atom. Each $R^{4b}$ independently represents a hydrogen atom or a methyl group, and preferably represents a hydrogen atom. s represents an integer of 1 or more, preferably 10 or less, and more preferably 7 or less.

Specific examples of compounds represented by formula (4a) include bis(4-maleimidophenyl)methane, 2,2-bis {4-(4-maleimidophenoxy)-phenyl}propane, and bis(3-ethyl-5-methyl-4-maleimidophenyl)methane. When the maleimide compound contains the maleimide compound represented by formula (4a), the coefficient of thermal expansion of the cured product to be obtained is further reduced, and the heat resistance and the glass transition temperature (Tg) tend to be further improved. The maleimide compounds may be used singly or in combinations of two or more.

As the maleimide compound, a commercially available product may be used, or a preparation prepared by a known method may be used. Examples of commercially available maleimide compounds include "BMI-70" and "BMI-80" manufactured by K·I Chemical Industry Co., Ltd., and "BMI-2300", "BMI-1000P", "BMI-3000", "BMI-4000", "BMI-5100", and "BMI-7000" manufactured by Daiwa Kasei Kogyo Co., Ltd.

The content of the maleimide compound is not particularly limited, but is preferably from 1 part by mass or more and 45 parts by mass or less based on 100 parts by mass of the resin solid content. When the content is within the above range, the cured product to be obtained tends to be more excellent in low water absorption and the warpage of a printed wiring board (particularly a thin substrate such as a multilayer coreless substrate) tends to be further reduced. From the same viewpoint, the lower limit value of the content is preferably 1 part by mass, more preferably 4 parts by mass, and still more preferably 10 parts by mass, and the upper limit value of the content is preferably 45 parts by mass, more preferably 40 parts by mass, still more preferably 30 parts by mass, and particularly preferably 20 parts by mass.

The organic resin of the present embodiment may contain or may not contain an elastomer (for example, an acrylic rubber, a silicone rubber, a core-shell rubber) in order to lower the elastic modulus of the cured product at a predetermined temperature.

The content of the elastomer is, for example, less than 30 parts by mass, preferably 25 parts by mass or less, more preferably 20 parts by mass or less, still more preferably 15 parts by mass or less, and particularly 10 parts by mass or less (preferably 5 parts by mass or less, more preferably 0 parts by mass) based on 100 parts by mass of the resin solid content. When the content is equal to or less than (less than) the above value, the heat resistance and water absorption of the cured product to be obtained tend to be further improved. The term "resin solid content" here refers to components excluding the solvent, the filler, and the elastomer, and 100 parts by mass of the resin solid content means that the total amount of the components excluding the solvent, the filler, and the elastomer in the resin composition is 100 parts by mass.

(Other resins)

The resin composition of the present embodiment may further contain another resin. Examples of other resins include alkenyl-substituted nadimide compounds, oxetane resins, benzoxazine compounds, and compounds having a polymerizable unsaturated group. These resins may be used singly or in combinations of two or more.

(Alkenyl-substituted nadimide compound)

As used herein, the "alkenyl-substituted nadimide compound" refers to a compound having one or more alkenyl-substituted nadimide groups in the molecule. Examples of alkenyl-substituted nadimide compounds include a compound represented by the following formula (5a):

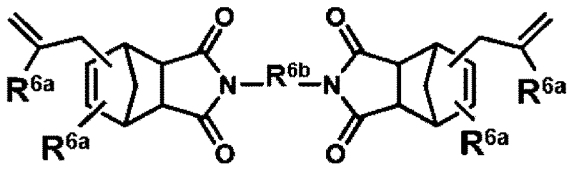

(5 a)

In formula (5a), each $R^{6a}$ independently represents a hydrogen atom or an alkyl group having 1 to 6 carbon atoms, and $R^{6b}$ represents an alkylene group having 1 to 6 carbon atoms, a phenylene group, a biphenylene group, and a naphthylene group, or a group represented by the following formula (5b) or (5c):

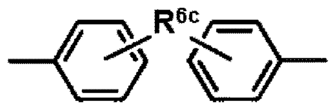

(5 b)

In formula (5b), $R^{6c}$ represents a methylene group, an isopropylidene group, or a substituent represented by CO, O, S, or $SO_2$.

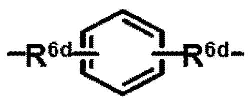

(5 c)

In formula (5c), each $R^{6d}$ independently represents an alkylene group having 1 to 4 carbon atoms or a cycloalkylene group having 5 to 8 carbon atoms.

Examples of alkenyl-substituted nadimide compounds include a compound represented by the following formulas (12) and/or (13):

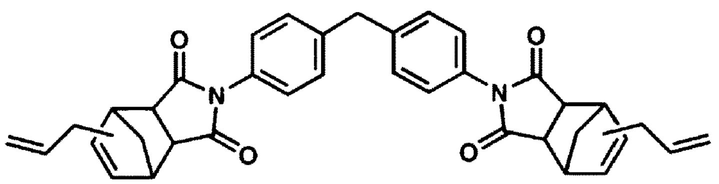

(12)

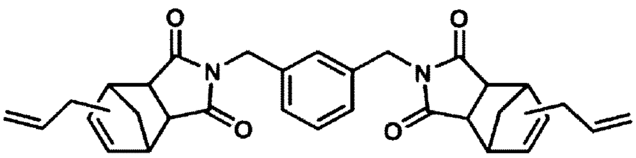

(13)

As the alkenyl-substituted nadimide compound, a commercially available product may be used, or a preparation prepared by a known method may be used. Examples of commercially available alkenyl-substituted nadimide compounds include, but not particularly limited to, "BANI-M" and "BANI-X" manufactured by Maruzen Petrochemical Co., Ltd.

(Oxetane Resin)

Examples of oxetane resins include oxetane, alkyloxetanes such as 2-methyloxetane, 2,2-dimethyloxetane, 3-methyloxetane, and 3,3-dimethyloxetane, 3-methyl-3-methoxymethyloxetane, 3,3'-di(trifluoromethyl)perfluoxetane, 2-chloromethyloxetane, 3,3-bis(chloromethyl)oxetane, biphenyl-based oxetane, "OXT-101", and "OXT-121" manufactured by Toagosei Co., Ltd.

(Benzoxazine compound)

As used herein, the term "benzoxazine compound" refers to a compound having two or more dihydrobenzoxazine rings in one molecule. Examples of benzoxazine compounds include "bisphenol F-based benzoxazine BF-BXZ" and

"bisphenol S-based benzoxazine BS-BXZ" manufactured by Konishi Chemical Co., Ltd.

(Compound having polymerizable unsaturated group)

Examples of compounds having a polymerizable unsaturated group include vinyl compounds such as ethylene, propylene, styrene, divinylbenzene, and divinylbiphenyl; (meth)acrylates of monohydric or polyhydric alcohols such as methyl (meth)acrylate, 2-hydroxyethyl (meth)acrylate, 2-hydroxypropyl (meth)acrylate, polypropylene glycol di(meth) acrylate, trimethylolpropane di(meth)acrylate, trimethylolpropane tri(meth)acrylate, pentaerythritol tetra(meth)acrylate, and dipentaerythritol hexa(meth)acrylate; epoxy (meth)acrylates such as bisphenol A-based epoxy (meth)acrylate and bisphenol F-based epoxy (meth)acrylate; and benzocyclobutene resins.

[Filler]

The resin composition of the present embodiment may further contain a filler. Examples of fillers include inorganic and/or organic fillers.

Examples of inorganic fillers include, but not particularly limited to, silicas, silicon compounds (for example, white carbon), metal oxides (for example, alumina, titanium white, zinc oxide, magnesium oxide, zirconium oxide), metal nitrides (for example, boron nitride, aggregated boron nitride, silicon nitride, aluminum nitride), metal sulfates (for example, barium sulfate), metal hydroxides (for example, aluminum hydroxide, aluminum hydroxide heat-treated product (for example, aluminum hydroxide heat-treated to reduce a part of water of crystallization), boehmite, magnesium hydroxide), molybdenum compounds (for example, molybdenum oxide, zinc molybdate), zinc compounds (for example, zinc borate, zinc stannate), clay, kaolin, talc, calcined clay, calcined kaolin, calcined talc, mica, E-glass, A-glass, NE-glass, C-glass, L-glass, D-glass, S-glass, M-glass G20, short glass fiber (including fine powders of glass such as E glass, T glass, D glass, S glass, glass) hollow glass, and spherical glass. These inorganic fillers may be used singly or in combinations of two or more. Among these, the filler is preferably at least one selected from the group consisting of silica, metal hydroxides, and metal oxides, and more preferably contains at least one selected from the group consisting of silica, boehmite, and alumina, and is still more preferably silica from the viewpoint of further improving the stiffness of the cured product to be obtained and further reducing the warpage of a printed wiring board (particularly a thin substrate such as a multilayer coreless substrate).

Examples of silicas include natural silica, fused silica, synthetic silica, amorphous silica, AEROSIL, and hollow silica. Among these, fused silica is preferred from the viewpoint of further improving the stiffness of the cured product to be obtained and further reducing the warpage of a printed wiring board (particularly a thin substrate such as a multilayer coreless substrate).

Examples of organic fillers include, but not particularly limited to, rubber powders such as styrene-based powder, butadiene-based powder, and acrylic-based powder; core-shell-based rubber powder; and silicone-based powder. These organic fillers may be used singly or in combinations of two or more. Among these, silicone-based powder is preferred from the viewpoint of further improving the stiffness of the cured product to be obtained and further reducing the warpage of a printed wiring board (particularly a thin substrate such as a multilayer coreless substrate).

Examples of silicone-based powders include silicone resin powder, silicone rubber powder, and silicone composite powder. Among these, silicone composite powder is preferred from the viewpoint of further improving the stiffness of the cured product to be obtained and further reducing the warpage of a printed wiring board (particularly a thin substrate such as a multilayer coreless substrate).

The filler of the present embodiment preferably contains an inorganic filler and an organic filler. As a result, the cured product to be obtained tends to be more excellent in stiffness, and the warpage of a printed wiring board (particularly a thin substrate such as a multilayer coreless substrate) tends to be further reduced.

The content of the inorganic filler is preferably from 90 parts by mass or more and 700 parts by mass or less based on 100 parts by mass of the resin solid content. When the content is within the above range, the stiffness of the cured product to be obtained tends to be further improved, and the warpage of a printed wiring board (particularly a thin substrate such as a multilayer coreless substrate) tends to be further reduced. From the same viewpoint, the lower limit value of the content is preferably 90 parts by mass, more preferably 120 parts by mass, and may be 140 parts by mass, and the upper limit value of the content is preferably 700 parts by mass, more preferably 600 parts by mass, still more preferably 500 parts by mass, and particularly preferably 250 parts by mass.

When the resin composition contains an organic filler, the content of the organic filler is preferably from 1 part by mass or more and 50 parts by mass or less based on 100 parts by mass of the resin solid content. When the content is within the above range, the stiffness of the cured product to be obtained tends to be further improved, and the warpage of a printed wiring board (particularly a thin substrate such as a multilayer coreless substrate) tends to be further reduced. From the same viewpoint, the lower limit value of the content is preferably 1 part by mass, more preferably 5 parts by mass, and may be 10 parts by mass, and the upper limit value of the content is preferably 50 parts by mass, more preferably 40 parts by

mass, still more preferably (less than) 30 parts by mass, and particularly preferably 25 parts by mass or less.

The content of the filler is preferably from 100 parts by mass or more and 700 parts by mass or less based on 100 parts by mass of the resin solid content. When the content is within the above range, the stiffness of the cured product to be obtained tends to be further improved, and the warpage of a printed wiring board (particularly a thin substrate such as a multilayer coreless substrate) tends to be further reduced. From the same viewpoint, the lower limit value of the content is preferably 100 parts by mass, more preferably 130 parts by mass, and may be 150 parts by mass, and the upper limit value of the content is preferably 700 parts by mass, more preferably 600 parts by mass, still more preferably 500 parts by mass, and particularly preferably 250 parts by mass.

[Silane coupling agent]

The resin composition of the present embodiment may further contain a silane coupling agent. When the resin composition of the present embodiment contains a silane coupling agent, the dispersibility of the filler tends to be further improved, and the adhesive strength between the components of the resin composition of the present embodiment and the base material described below tends to be further improved.

Examples of silane coupling agents include, but not particularly limited to, silane coupling agents generally used for surface treatment of inorganic substances, including aminosilane-based compounds (for example, γ-aminopropyltriethoxysilane, N-β-(aminoethyl)-γ-aminopropyltrimethoxysilane), epoxysilane-based compounds (for example, γ-glycidoxypropyltrimethoxysilane), acrylsilane-based compounds (for example, γ-acryloxypropyltrimethoxysilane), cationic silane-based compounds (for example, N-β-(N-vinylbenzylaminoethyl)-γ-aminopropyltrimethoxysilane hydrochloride), and phenylsilane-based compounds. The silane coupling agents is used singly or in combinations of two or more. Among these, the silane coupling agent is preferably an epoxy silane compound. Examples of epoxysilane-based compounds include "KBM-403", "KBM-303", "KBM-402", and "KBE-403" manufactured by Shin-Etsu Chemical Co., Ltd.

The content of the silane coupling agent is not particularly limited, but may be 0.1 to 5.0 parts by mass based on 100 parts by mass of the resin solid content.

[Wetting and dispersing agent]

The resin composition of the present embodiment may further contain a wetting and dispersing agent. When the resin composition of the present embodiment contains a wetting and dispersing agent, the dispersibility of the filler tends to be further improved, the stiffness of the cured product to be obtained tends to be further improved, the warpage of a metal foil-clad laminate, a printed wiring board, and a multilayer printed wiring board (particularly, the multilayer coreless substrate) tends to be further reduced.

The wetting and dispersing agent may be any known dispersing agent (dispersion stabilizer) used for dispersing a filler, and examples thereof include wetting and dispersing agents such as DISPERBYK-110, 111, 118, 180, and 161 and BYK-W996, W9010, and W903 manufactured by BYK Japan KK.

The content of the wetting and dispersing agent is not particularly limited, but is preferably 1.0 part by mass or more and 5.0 parts by mass or less based on 100 parts by mass of the resin solid content. When the content is within the above range, the dispersibility of the filler tends to be further improved, the stiffness of the cured product to be obtained tends to be further improved, the warpage of a metal foil-clad laminate, a printed wiring board, and a multilayer printed wiring board (particularly, the multilayer coreless substrate) tends to be further reduced. From the same viewpoint, the lower limit value of the content is preferably 1.0 part by mass, more preferably 1.5 parts by mass, and still more preferably 2.0 parts by mass.

[Curing accelerator]

The resin composition of the present embodiment may further contain a curing accelerator. Examples of curing accelerators include, but not particularly limited to, imidazoles (for example, triphenylimidazole); organic peroxides (for example, benzoyl peroxide, lauroyl peroxide, acetyl peroxide, parachlorobenzoyl peroxide, di-tert-butyl-di-perphthalate); azo compounds (for example, azobisnitrile); tertiary amines (for example, N,N-dimethylbenzylamine, N,N-dimethylaniline, N,N-dimethyltoluidine, N,N-dimethylpyridine, 2-N-ethylanilinoethanol, tri-n-butylamine, pyridine, quinoline, N-methylmorpholine, triethanolamine, triethylenediamine, tetramethylbutanediamine, N-methylpiperidine); phenols (for example, phenol, xylenol, cresol, resorcin, catechol); organometallic salts (for example, lead naphthenate, lead stearate, zinc naphthenate, zinc octylate, tin oleate, dibutyltin maleate, manganese naphthenate, cobalt naphthenate, acetylacetone iron); products obtained by dissolving these organometallic salts in a hydroxyl group-containing compound such as phenol, bisphenol; inorganic metallic salts (for example, tin chloride, zinc chloride, aluminum chloride); and organotin compounds (for example, dioctyltin oxide and other alkyltins, alkyltin oxides). These curing accelerators may be used singly or in combinations of two or more. Among them, the curing accelerator is preferably triphenylimidazole from the

viewpoint of accelerating the curing reaction and further improving the glass transition temperature (Tg) of the cured product to be obtained.

[Solvent]

The resin composition of the present embodiment may further contain a solvent. When the resin composition of the present embodiment contains a solvent, the viscosity at the time of preparing the resin composition tends to be reduced, the handling property (handleability) tends to be further improved, and the impregnation of the base material tends to be further improved.

The solvent is not particularly limited as long as it can dissolve part or all of the organic resin in the resin composition, and examples thereof include ketones (acetone, methyl ethyl ketone, methyl cellosolve) and aromatic hydrocarbons (for example, toluene, xylene), amides (for example, dimethylformaldehyde), and propylene glycol monomethyl ether and acetate thereof. These solvents may be used singly or in combinations of two or more.

Examples of a method for producing the resin composition of the present embodiment include a method in which each component is blended in a solvent at once or sequentially and then stirred. At this time, in order to uniformly dissolve or disperse each component, known processes such as stirring, mixing, and kneading may be used.

[Applications]

As described above, the resin composition of the present embodiment can sufficiently reduce the warpage of a metal foil-clad laminate, a printed wiring board, and a multilayer printed wiring board (particularly, a multilayer coreless substrate) and can exhibit excellent stiffness and heat resistance. For this reason, the resin composition of the present embodiment is used for a metal foil-clad laminate, a printed wiring board, and a multilayer printed wiring board. Since the problem of warpage is particularly remarkable in a multilayer coreless substrate, the resin composition of the present embodiment is suitably used for a multilayer coreless substrate. The resin composition of the present embodiment is suitably used also for a prepreg, an insulating layer, and a laminate.

[Prepreg]

A prepreg of the present embodiment includes a base material and the resin composition of the present embodiment with which the base material is impregnated or coated. As described above, the prepreg may be a prepreg obtained by a known method, and specifically, the prepreg may be obtained by impregnating or coating a base material with the resin composition of the present embodiment, and then heating and drying at 100 to 200°C to thereby cause semi-curing (B-staging) of the resin composition.

The prepreg of the present embodiment also encompasses the form of a cured product obtained by thermally curing a semi-cured prepreg at a heating temperature of 200 to 230°C and a heating time of 60 to 180 minutes.

The content of the resin composition in the prepreg is preferably 30 to 90 volume%, more preferably 35 to 85 volume%, and still more preferably 40 to 80 volume% in terms of solid content, based on the total amount of the prepreg. When the content of the resin composition is within the above range, molability tends to be further improved. Here, the solid content here refers to a component obtained by removing the solvent from the resin composition, and the filler is included in the solid content.

(Base material)

Examples of base materials include, but not particularly limited to, known base materials used for various printed wiring board materials. Specific examples of base material include glass base materials, inorganic base materials other than glass (for example, inorganic base materials made of inorganic fibers other than glass such as quartz), organic base materials (for example, organic base materials made of organic fibers such as wholly aromatic polyamide, polyester, polyparaphenylenebenzoxazole, and polyimide). These base materials may be used singly or in combinations of two or more. Among these, a glass base material is preferable from the viewpoint of further improving the stiffness and further improving the dimensional stability upon heating.

(Glass base material)

Examples of fiber constituting the glass base material include E glass, D glass, S glass, T glass, Q glass, L glass, NE glass, and HME glass. Among these, the fiber constituting the glass base material is preferably one or more fibers selected from the group consisting of E glass, D glass, S glass, T glass, Q glass, L glass, NE glass, and HME glass from the viewpoint of further improving strength and low water absorption.

Examples of forms of the base material include, but not particularly limited to, forms such as woven fabric, nonwoven fabric, roving, chopped strand mat, and surfacing mat. The weaving method of the woven fabric is not particularly limited, but, for example, plain weaving, seaweed weaving, twill weaving are known, and can be appropriately selected from these known methods depending on the intended application or performance. Further, those obtained by subjecting these to fiber opening treatment and glass woven fabrics surface-treated with a silane coupling agent are preferably used. The thickness and mass of the base material are not particularly limited, but usually those having a thickness of 0.01 to 0.1 mm are preferably used.

[Laminate]

A laminate of the present embodiment has the prepreg of the present embodiment. The laminate of the present embodiment includes one or more prepregs, and in the case of including a plurality of prepregs, has a form in which the prepregs are laminated. When the laminate of the present embodiment has the prepreg of the present embodiment, the warpage is sufficiently reduced, and excellent stiffness and heat resistance are exhibited.

[Metal foil-clad laminate]

The metal foil-clad laminate of the present embodiment has the prepreg of the present embodiment and a metal foil disposed on one or both sides of the prepreg. The metal foil-clad laminate of the present embodiment includes one or more prepregs. When the number of prepregs is one, the metal foil-clad laminate has a form in which a metal foil is disposed on one or both sides of the prepreg. When the number of prepregs is two or more, the metal foil-clad laminate has a form in which a metal foil is disposed on one side or both sides of each of the laminated prepregs (laminate of prepregs). When the metal foil-clad laminate of the present embodiment has the prepreg of the present embodiment, the warpage is sufficiently reduced, and excellent stiffness and heat resistance are exhibited.

The metal foil (conductor layer) may be any metal foil used for various printed wiring board materials, examples thereof include foils of metal such as copper and aluminum, and examples of metal foils of copper include copper foils of rolled copper foil and electrolytic copper foil. The thickness of the conductor layer is, for example, 1 to 70 $\mu$m, and preferably 1.5 to 35 $\mu$m.

The method for molding the laminate and the metal foil-clad laminate and the molding conditions thereof are not particularly limited, and methods and conditions for general laminates and multilayer boards for printed wiring boards may be applied. For example, when molding the laminate or the metal foil-clad laminate, a multi-stage press, a multi-stage vacuum press, a continuous molding machine, an autoclave molding machine, may be used. In molding the laminate or the metal foil-clad laminate (lamination molding), the temperature is generally 100 to 300°C, the pressure is 2 to 100 kgf/cm$^2$, and the heating time is generally 0.05 to 5 hours. Further, if necessary, post-curing may be performed at a temperature of 150 to 300°C. In particular, when a multi-stage press is used, from the viewpoint of sufficiently accelerating the curing of the prepreg, the temperature is preferably 200°C to 250°C, the pressure is preferably 10 to 40 kgf/cm$^2$, the heating time is preferably 80 minutes to 130 minutes, and the temperature is more preferably 215°C to 235°C, the pressure is more preferably 25 to 35 kgf/cm$^2$, and the heating time is more preferably 90 to 120 minutes. The multilayer board may also be fabricated by laminate-molding the above-described prepreg and a separately fabricated wiring board for an inner layer in combination.

[Printed wiring board]

A printed wiring board of the present embodiment has an insulating layer formed of the prepreg of the present embodiment and a conductor layer disposed on a surface of the insulating layer. The printed wiring board of the present embodiment may be formed by, for example, etching the metal foil of the metal foil-clad laminate of the present embodiment into a predetermined wiring pattern to form a conductor layer. Since the printed wiring board of the present embodiment has the prepreg of the present embodiment, the warpage is sufficiently reduced, and excellent stiffness and heat resistance are exhibited.

Specifically, the printed wiring board of the present embodiment may be manufactured, for example, by the following method. First, a metal foil-clad laminate of the present embodiment is provided. The metal foil of the metal foil-clad laminate is etched into a predetermined wiring pattern to fabricate an inner layer substrate having a conductor layer (inner layer circuit). Next, a predetermined number of the prepregs and a metal foil for an outer layer circuit are laminated in this order on a surface of the conductor layer (interior circuit) of the inner layer substrate, and are heated and pressed and thereby integrally molded (lamination molding) to obtain a laminate. The method of lamination molding and the molding conditions are the same as the method of lamination molding of the laminate and the metal foil-clad laminate and the molding conditions thereof. Next, the laminate is subjected to perforation for a through-hole and a via hole, and a plated metal film is formed on the wall surface of the hole thus formed to allow conduction between the conductor layer (interior

circuit) and the metal foil for the outer layer circuit. Next, the metal foil for the outer layer circuit is etched into a predetermined wiring pattern to fabricate an outer layer substrate having a conductor layer (outer layer circuit). The printed wiring board is thus manufactured.

When the metal foil-clad laminate is not used, the printed wiring board may be produced by forming a conductor layer serving as a circuit on the prepreg. At this time, an electroless plating technique may be used for forming the conductor layer.

[Multilayer printed wiring board (multilayer coreless substrate)]

The multilayer printed wiring board according to the present embodiment includes a plurality of insulating layers including a first insulating layer and one or more second insulating layers laminated on one side of the first insulating layer, and a plurality of conductor layers including a first conductor layer disposed between adjacent two of the plurality of insulating layers and a second conductor layer disposed on a surface of an outermost layer of the plurality of insulating layers, and each of the first insulating layer and the second insulating layer has the cured product of the prepreg of the present embodiment. Figure 9 shows a specific example of the multilayer printed wiring board of the present embodiment. The multilayer printed wiring board shown in Figure 9 includes a first insulating layer (1) and two second insulating layers (2) laminated on one side (on the lower surface in the drawing) of the first insulating layer (1), and the first insulating layer (1) and the two second insulating layers (2) are each formed of one prepreg of the present embodiment. Further, the multilayer printed wiring board shown in Figure 9 has a plurality of conductor layers including a first conductor layer (3) disposed between adjacent two of the plurality of insulating layers (1,2) and a second conductor layer (3) disposed on an outermost layer of the plurality of insulating layers (1,2).

The multilayer printed wiring board of the present embodiment is, for example, a so-called coreless type multilayer printed wiring board (multilayer coreless substrate) in which a second insulating layer is laminated only on one side of a first insulating layer. In multilayer coreless substrates, usually, only on one side of an insulating layer formed of a prepreg, another insulating layer formed of another prepreg laminated, so that the problem of warpage of the substrate is remarkable. On the other hand, since the multilayer printed wiring board of the present embodiment has the prepreg of the present embodiment, the warpage is sufficiently reduced, and excellent stiffness and heat resistance are exhibited. Therefore, the resin composition of the present embodiment can sufficiently reduce warpage (achieve low warpage) in a multilayer coreless substrate, and can thus be effectively used as a multilayer coreless substrate for a semiconductor package.

For the multilayer printed wiring board of the present embodiment, the method described in the Example section of the present application may be referred to, for example.

Hereinafter, the present invention will be further described with reference to Examples and Comparative Examples, but the present invention is not limited to these Examples in any way.

[Synthesis Example 1]

An $\alpha$-naphthol aralkyl-based cyanate compound (SN495VCN) was synthesized and used according to the following procedure.

An $\alpha$-naphthol aralkyl resin (SN495V, OH group equivalent: 236 g/eq., manufactured by Nippon Steel Chemical Co., Ltd.: the number of repeating units n of naphthol aralkyl includes 1 to 5) 0.47 mol (OH group conversion) was dissolved in 500 ml of chloroform, and 0.7 mol of triethylamine was added to this solution (solution 1). While maintaining the temperature at -10°C, the solution 1 was added dropwise to 300 g of a chloroform solution in which 0.93 mol of cyan chloride was dissolved over 1.5 hours, and after completion of the dropwise addition, the mixture was stirred for 30 minutes. Thereafter, a mixed solution of 0.1 mol of triethylamine and 30 g of chloroform was added dropwise into the reactor and stirred for 30 minutes to complete the reaction. After triethylamine hydrochloride formed as a by-product was filtered off from the reaction liquid, the obtained filtrate was washed with 500 ml of 0.1N hydrochloric acid, and then washed with 500 ml of water four times. This was dried with sodium sulfate and evaporated at 75°C, and further degassed at 90°C under reduced pressure to obtain the $\alpha$-naphthol aralkyl-based cyanate compound represented by the formula (1a) in the form of a brown solid (wherein $R^{1d}$ are all hydrogen atoms). When the obtained $\alpha$-naphthol aralkyl-based cyanate compound was analyzed with infrared absorption spectrum, absorption of the cyanate group was confirmed in the vicinity of 2264 $cm^{-1}$.

[Example 1]

36 parts by mass of biphenyl aralkyl-based phenolic compound (KAYAHARD GPH-103, manufactured by Nippon Kayaku Co., Ltd., hydroxyl group equivalent: 231 g/eq.), 39 parts by mass of biphenyl aralkyl-based epoxy resin (NC-3000-FH, epoxy equivalent: 320 g/eq., manufactured by Nippon Kayaku Co., Ltd.), 7 parts by mass of naphthalene

aralkyl-based epoxy resin (HP-9900, epoxy equivalent: 274 g/eq., manufactured by DIC Corporation), 18 parts by mass of bis(3-ethyl-5-methyl-4-maleimidodiphenyl)methane) (BMI-70, manufactured by K·I Chemical Industry Co., Ltd.), 100 parts by mass of slurry silica 1 (SC2050-MB, average particle size 0.7 μm, manufactured by Admatechs Co., Ltd.), 100 mass of slurry silica 2 (SC5050-MOB, average particle size 1.5 μm, manufactured by Admatechs Co., Ltd.), 20 parts by mass of silicone composite powder (KMP-600, manufactured by Nissin Chemical Industry Co., Ltd.), 1 part by mass of wetting and dispersing agent 1 (DISPERBYK-161, manufactured by BYK Japan KK), 2 parts by mass of wetting and dispersing agent 2 (DISPERBYK-111, manufactured by BYK Japan KK), 1 part by mass of silane coupling agent (KBM-403, manufactured by Shin-Etsu Chemical Co., Ltd.), and 0.5 parts by mass of 2,4,5-triphenylimidazole (manufactured by Tokyo Chemical Industry Co., Ltd.) were blended(mixed), and then diluted with methyl ethyl ketone to obtain a varnish (resin composition). E glass (IPC #1030 manufactured by Unitika Ltd.) was impregnated and coated with the varnish (resin composition), and then dried by heating at 160°C for 3 minutes to obtain a prepreg. The content of the resin composition (solid content) in the obtained prepreg was 73 volume%.

[Example 2]

A prepreg was obtained in the same manner as in Example 1, except that the amount of the biphenyl aralkyl-based epoxy resin (NC-3000-FH) was changed to 19 parts by mass instead of 39 parts by mass, and 20 parts by mass of naphthylene ether-based epoxy resin (HP-6000, epoxy equivalent: 250 g/eq., manufactured by DIC Corporation) was added. The content of the resin composition (solid content) in the obtained prepreg was 73 volume%.

[Example 3]

A prepreg was obtained in the same manner as in Example 1, except that the slurry silica 2 (SC-5050MOB) and the wetting and dispersing agent 2 (DISPERBYK-111) were not used. The content of the resin composition (solid content) in the obtained prepreg was 73 volume%.

[Example 4]

A prepreg was obtained in the same manner as in Example 1, except that the amount of the slurry silica 2 (SC-5050MOB) was changed to 50 parts by mass instead of 100 parts by mass, and the wetting and dispersing agent 2 (DISPERBYK-111) was not used. The content of the resin composition (solid content) in the obtained prepreg was 73 volume%.

[Example 5]

20 parts by mass of biphenyl aralkyl-based phenolic compound (KAYAHARD GPH-103), 15 parts by mass of phenol-modified xylene compound (Xistar GP-100, Fudow Co., Ltd., phenol equivalent: 194 g/eq.), 34 parts by mass of biphenyl aralkyl-based epoxy resin (NC-3000-FH), 5 parts by mass of naphthalene aralkyl-based epoxy resin (HP-9900), 7 parts by mass of dicyclopentadiene-based epoxy resin (HP-7200L, epoxy equivalent: 249 g/eq., manufactured by DIC Corporation), 19 parts by mass of polyphenylmethane maleimide compound (BMI-2300, manufactured by Daiwakasei Industry Co., Ltd.), 100 parts by mass of slurry silica 1 (SC2050-MB, average particle size 0.7 μm), 100 mass of slurry silica 2 (SC5050-MOB, average particle size 1.5 μm), 20 parts by mass of silicone composite powder (KMP-600), 1 part by mass of wetting and dispersing agent 1 (DISPERBYK-161), 2 parts by mass of wetting and dispersing agent 2 (DISPERBYK-111), 1 part by mass of silane coupling agent (KBM-403), and 0.5 parts by mass of 2,4,5-triphenylimidazole were mixed, and then diluted with methyl ethyl ketone to obtain a varnish (resin composition). E glass (IPC #1030 manufactured by Unitika Ltd.) was impregnated and coated with the varnish (resin composition), and dried by heating at 160°C for 3 minutes to obtain a prepreg. The content of the resin composition (solid content) in the prepreg was 73 volume%.

[Example 6]

41 parts by mass of naphthol aralkyl-based phenolic compound (SN-495V, manufactured by Nippon Steel Chemical Co., Ltd., hydroxyl group equivalent: 236 g/eq.), 45 parts by mass of biphenyl aralkyl-based epoxy resin (NC-3000-FH), 9 parts by mass of naphthalene aralkyl-based epoxy resin (HP-9900), 5 parts by mass of bis(3-ethyl-5-methyl-4-maleimidiphenyl)methane (BMI-70), 100 parts by mass of slurry silica 1 (SC2050-MB, average particle size: 0.7 μm), 100 parts by mass of slurry silica 2 (SC5050-MOB, average particle size 1.5 μm), 20 parts by mass of silicone composite powder (KMP-600), 1 part by mass of wetting and dispersing agent 1 (DISPERBYK-161), 2 parts by mass of wetting and dispersing agent 2 (DISPERBYK-111), 1 part by mass of silane coupling agent (KBM-403), and 0.5 part by mass of 2,4,5-triphenylimidazole were mixed and then diluted with methyl ethyl ketone to obtain a varnish (resin

composition). E glass (IPC #1030 manufactured by Unitika Ltd.) was impregnated and coated with the varnish (resin composition), and dried by heating at 160°C for 3 minutes to obtain a prepreg. The content of the resin composition (solid content) in the prepreg was 73 volume%.

[Example 7]

34 parts by mass of the α-naphthol aralkyl-based cyanate compound (cyanate equivalent: 261 g/eq) synthesized by the method described in Synthesis Example 1, 15 parts by mass of biphenyl aralkyl-based epoxy resin (NC-3000-FH), 5 parts by mass of naphthylene ether-based epoxy resin (HP-6000), 26 parts by mass of dicyclopentadiene-based epoxy resin (HP-7200L), 15 parts by mass of epoxy resin including a bisphenol A-based structural unit and a hydrocarbon-based structural unit (EPICLON EXA-4816, manufactured by DIC Corporation, epoxy equivalent: 403 g/eq.), 5 parts by mass of bis(3-ethyl-5-methyl-maleimidophenyl)methane (BMI-70), 100 parts by mass of slurry silica 1 (SC2050-MB, average particle size 0.7 μm), 100 parts by mass of slurry silica 2 (SC5050-MOB, average particle size 1.5 μm), 20 parts by mass of silicone composite powder (KMP-600), 1 part by mass of wetting and dispersing agent 1 (DISPERBYK-161), 2 parts by mass of wetting and dispersing agent 2 (DISPERBYK-111), 1 part by mass of silane coupling agent (KBM-403), and 0.5 parts by mass of 2,4,5-triphenylimidazole were mixed, and then diluted with methyl ethyl ketone to obtain a varnish (resin composition). E glass (IPC #1030 manufactured by Unitika Ltd.) was impregnated and coated with the varnish (resin composition), and dried by heating at 160°C for 3 minutes to obtain a prepreg. The content of the resin composition (solid content) of the obtained prepreg was 73 volume%.

[Example 8]

21 parts by mass of bisphenol A-based cyanate compound (CA210, manufactured by Mitsubishi Gas Chemical Company, Inc., cyanate equivalent: 139 g/eq.), 5 parts by mass of bis(3-ethyl-5-methyl-maleimidophenyl)methane (BMI-70), 15 parts by mass of biphenyl aralkyl-based epoxy resin (NC-3000-FH), 5 parts by mass of naphthylene ether-based epoxy resin (HP-6000), 54 parts by mass of dicyclopentadiene-based epoxy resin (HP-7200L), 100 parts by mass of slurry silica 1 (SC2050-MB, average particle size 0.7 μm), 100 parts by mass of slurry silica 2 (SC5050-MOB, average particle size 1.5 μm), 20 parts by mass of silicone composite powder (KMP-600), 1 part by mass of wetting and dispersing agent 1 (DISPERBYK-161), 2 parts by mass of wetting and dispersing agent 2 (DISPERBYK-111), 1 part by mass of silane coupling agent (KBM-403), and 0.5 parts by mass of 2,4,5-triphenylimidazole were mixed, and then diluted with methyl ethyl ketone to obtain a varnish (resin composition). E glass (IPC #1030 manufactured by Unitika Ltd.) was impregnated and coated with the varnish (resin composition), and dried by heating at 160°C for 3 minutes to obtain a prepreg. The content of the resin composition (solid content) of the obtained prepreg was 73 volume%.

[Comparative Example 1]

40 parts by mass of the α-naphthol aralkyl-based cyanate compound (cyanate equivalent: 261 g/eq) synthesized by the method described in Synthesis Example 1, 20 parts by mass of polyphenylmethane maleimide compound (BMI-2300), 40 parts by mass of naphthylene ether-based epoxy resin (HP-6000), 100 parts by mass of slurry silica 1 (SC2050-MB, average particle size 0.7 μm), 100 parts by mass of slurry silica 2 (SC5050-MOB, average particle size 1.5 μm), 20 parts by mass of silicone composite powder (KMP-600), 1 part by mass of wetting and dispersing agent 1 (DISPERBYK-161), 2 parts by mass of wetting and dispersing agent 2 (DISPERBYK-111), 1 part by mass of silane coupling agent (KBM-403), and 0.5 parts by mass of 2,4,5-triphenylimidazole were mixed, and then diluted with methyl ethyl ketone to obtain a varnish (resin composition). E glass (IPC #1030 manufactured by Unitika Ltd.) was impregnated and coated with the varnish (resin composition), and dried by heating at 160°C for 3 minutes to obtain a prepreg. The content of the resin composition (solid content) of the obtained prepreg was 73 volume%.

[Comparative Example 2]

20 parts by mass of biphenyl aralkyl-based phenolic compound (KAYAHARD GPH-103), 15 parts by mass of phenol-modified xylene compound (Xistar GP-100), 30 parts by mass of biphenyl aralkyl-based epoxy resin (NC-3000-FH), 20 parts by mass of dicyclopentadiene-based epoxy resin (HP-7200L), 15 parts by mass of bis(3-ethyl-5-methyl-maleimidophenyl)methane (BMI-70), 100 parts by mass of slurry silica 1 (SC2050-MB, average particle size 0.7 μm), 100 parts by mass of slurry silica 2 (SC5050-MOB, average particle size 1.5 μm), 20 parts by mass of silicone composite powder (KMP-600), 1 part by mass of wetting and dispersing agent 1 (DISPERBYK-161), 2 parts by mass of wetting and dispersing agent 2 (DISPERBYK-111), 1 part by mass of the silane coupling agent (KBM-403), and 0.5 parts by mass of 2,4,5-triphenylimidazole were mixed, and then diluted with methyl ethyl ketone to obtain a varnish (resin composition). E glass (IPC #1030 manufactured by Unitika Ltd.) was impregnated and coated with the varnish (resin composition), and

dried by heating at 160°C for 3 minutes to obtain a prepreg. The content of the resin composition (solid content) in the obtained prepreg was 73 volume%.

[Comparative Example 3]

5 parts by mass of the α-naphthol aralkyl-based cyanate compound synthesized by the method described in Synthesis Example 1, 50 parts by mass of polyphenylmethane maleimide compound (BMI-2300), 10 parts by mass of biphenyl aralkyl-based epoxy resin (NC-3000-FH), 35 parts by mass of alkenyl-substituted nadimide compound (BANI-M, manufactured by Maruzen Petrochemical Co., Ltd.), 100 parts by mass of slurry silica 1 (SC2050-MB, average particle size 0.7 μm), 100 parts by mass of slurry silica 2 (SC5050-MOB, average particle size of 1.5 μm), 20 parts by mass of silicone composite powder (KMP-600), 1 part by mass of wetting and dispersing agent 1 (DISPERBYK-161), 2 parts by mass of wetting and dispersing agent 2 (DISPERBYK-111), 1 part by mass of silane coupling agent (KBM-403), and 0.5 parts by mass of 2,4,5-triphenylimidazole were mixed, and then diluted with methyl ethyl ketone to obtain a varnish (resin composition). E glass (IPC #1030 manufactured by Unitika Ltd.) was impregnated and coated with the varnish (resin composition), and dried by heating at 160°C for 3 minutes to obtain a prepreg. The content (solid content) of the resin composition in the obtained prepreg was 73 volume%.

[Comparative Example 4]

30 parts by mass of the α-naphthol aralkyl-based cyanate compound synthesized by the method described in Synthesis Example 1, 35 parts by mass of polyphenylmethane maleimide compound (BMI-2300), 5 parts by mass of naphthylene ether-based epoxy resin (HP-6000), 30 parts by mass of acrylate rubber compound (Teisan Resin SG-P3, manufactured by Nagase ChemteX Corporation), 100 parts by mass of slurry silica 1 (SC2050-MB, average particle size 0.7 μm), 100 parts by mass of slurry silica 2 (SC5050-MOB), 1 part by mass of wetting and dispersing agent 1 (DISPERBYK-161), 2 parts by mass of wetting and dispersing agent 2 (DISPERBYK-111), 1 part by mass of silane coupling agent (KBM-403), and 0.5 parts by mass of 2,4,5-triphenylimidazole were mixed, and then diluted with methyl ethyl ketone to obtain a varnish (resin composition). E glass (IPC #1030 manufactured by Unitika Ltd.) was impregnated and coated with the varnish (resin composition), and dried by heating at 160°C for 3 minutes to obtain a prepreg. The content of the resin composition (solid content) in the obtained prepreg was 73 volume%.

[Comparative Example 5]

A prepreg was obtained in the same manner as in Comparative Example 4, except that the slurry silica 2 (SC5050-MOB) and the wetting and dispersing agent 2 (DISPERBYK-111) were not used, and the amount of the slurry silica 1 (SC-2050MB) was changed to 75 parts by mass instead of 100 parts by mass. The content of the resin composition (solid content) in the obtained prepreg was 73 volume%.

(Physical property measurement and evaluation)

Using the prepregs obtained in Examples 1 to 8 and Comparative Examples 1 to 5, samples for measuring and evaluating physical properties were prepared according to the procedures shown in the following sections, and mechanical properties (storage moduli at 40°C, 170°C, 230°C, 260°C), glass transition temperature (Tg), amount of warpage (two types), water absorption rate, and stiffness were measured and evaluated. The results of Examples are summarized in Table 1, and the results of Comparative Examples are summarized in Table 2.

(Mechanical properties)

A copper foil (3EC-VLP, manufactured by Mitsui Mining & Smelting Co., Ltd., thickness 12 μm) was disposed on each of the upper and lower surfaces of one prepreg obtained in Examples 1 to 8 and Comparative Examples 1 to 5, and lamination molding (thermal curing) was performed at a pressure of 30 $kgf/cm^2$ and a temperature of 230°C for 100 minutes to obtain a copper foil-clad laminate having an insulating layer formed of a prepreg and a copper foil. The thickness of the insulating layer of this copper foil-clad laminate was about 45 μm. The obtained copper foil-clad laminate was cut to a size of 5.0 mm × 20 mm by a dicing saw, and then the copper foil on the surfaces was removed by etching, to obtain a sample for measurement. The mechanical properties (storage moduli E' at 40°C, 170°C, 230°C, 260°C) were measured by a dynamic viscoelasticity analyzer (manufactured by TA Instruments) by a DMA method in accordance with JIS C6481 using this sample for measurement (average value when n = 3).

[Glass transition temperature (Tg)]

A copper foil (3EC-VLP, thickness 12 μm) was disposed on each of the upper and lower surfaces of one prepreg obtained in Examples 1 to 8 and Comparative Examples 1 to 5, and lamination molding (thermal curing) was performed at a pressure of 30 $kgf/cm^2$ and a temperature of 230°C for 100 minutes to obtain a copper foil-clad laminate having an insulating layer formed of a prepreg and a copper foil. The thickness of the insulating layer of this copper foil-clad laminate was about 45 μm. The obtained copper foil-clad laminate was cut to a size of 12.7 mm × 2.5 mm by a dicing saw, and then the copper foil on the surfaces was removed by etching, to obtain a sample for measurement. The glass transition temperature (Tg) was measured by a dynamic viscoelasticity analyzer (manufactured by TA Instruments) by a DMA method in accordance with JIS C6481 using this sample for measurement (average value when n = 3).

[Amount of warpage: bimetal method]

First, a copper foil (3EC-VLP, thickness 12 μm) was disposed on each of the upper and lower surfaces of one prepreg obtained in Examples 1 to 8 and Comparative Examples 1 to 5, and lamination molding (thermal curing) was performed at a pressure of 30 $kgf/cm^2$ and a temperature of 220°C for 120 minutes to obtain a copper foil-clad laminate. Next, the copper foil was removed from the obtained copper foil-clad laminate by etching. Subsequently, one prepreg obtained in Examples 1 to 8 and Comparative Examples 1 to 5 was further provided on one side of the laminate from which the copper foil had been removed, the above copper foil (3EC-VLP, thickness 12 μm) was disposed on each of the upper and lower surfaces thereof, and lamination molding (thermal curing) was performed at a pressure of 30 $kgf/cm^2$ and a temperature of 220°C for 120 minutes to obtain a copper foil-clad laminate again. Further, the copper foil was removed from the obtained copper foil-clad laminate by etching to obtain a laminate. Then, a rectangular plate of 20 mm × 200 mm was cut out from the obtained laminate, the maximum value of the amount of warpage at both ends in the longitudinal direction was measured with a metal scale with the surface of the prepreg laminated on the second plate facing upward, and the average value thereof was defined as the "amount of warpage" by the bimetal method.

[Amount of warpage: multilayer coreless substrate]

First, as shown in Figure 1, an ultra-thin copper foil with carrier (b1) (MT18Ex, manufactured by Mitsui Mining & Smelting Co., Ltd., thickness 5 μm) was disposed on both surfaces of a prepreg serving as a support (a) with the carrier copper foil surface facing the prepreg side, and a prepreg (c1) obtained in Examples 1 to 8 and Comparative Examples 1 to 5 was further disposed thereon, and a copper foil (d) (3EC-VLP, thickness 12 μm) was further disposed thereon, and lamination molding was performed at a pressure of 30 $kgf/cm^2$ and a temperature of 220°C for 120 minutes to obtain a copper foil-clad laminate shown in Figure 2.

Subsequently, the copper foil (d) of the obtained copper foil-clad laminate shown in Figure 2 was etched into a predetermined wiring pattern, for example, as shown in Figure 3, to form a conductor layer (d'). Next, as shown in Figure 4, a prepreg (c2) obtained in Examples 1 to 8 and Comparative Examples 1 to 5 was disposed on the laminate shown in Figure 3 on which the conductor layer (d') had been formed, and then, an ultra-thin copper foil with carrier (b2) (MT18Ex, thickness 5 μm) was further disposed thereon, and lamination molding was performed at a pressure of 30 $kgf/cm^2$ and a temperature of 230°C for 120 minutes to obtain a copper foil-clad laminate shown in Figure 5.

Subsequently, in the copper foil-clad laminate shown in Figure 5, the carrier copper foil and the ultra-thin copper foil of the ultra-thin copper foil with carrier (b1) disposed on the support (a) (cured prepreg for the support) were peeled off from each other, and as a result, as shown in Figure 6, two laminates were peeled off from the support (a), and further, the carrier copper foil was peeled off from the ultra-thin copper foil with carrier (b2) on each of those laminates. Next, the upper and lower ultra-thin copper foils of the obtained laminates were processed by a laser processing machine, and as shown in Figure 7, predetermined vias (v) were formed by chemical copper plating. Then, as shown in Figure 8, for example, etching was performed to form a predetermined wiring pattern and to form a conductor layer, whereby a panel (size: 500 mm × 400 mm) of a multilayer coreless substrate was obtained. Then, the amounts of warpage at a total of eight locations of the four corners and the center of the four sides of the obtained panel were measured with a metal scale, and the average value thereof was defined as the "amount of warpage" of the panel of the multilayer coreless substrate.

[Heat resistance]

Nine prepregs obtained in Examples 1 to 8 and Comparative Examples 1 to 5 were laminated and a copper foil (3EC-VLP, thickness 12 μm) was disposed on each of the upper and lower surfaces thereof, and lamination molding (thermal curing) was performed at a pressure of 30 $kgf/cm^2$ and a temperature of 230°C for 100 minutes to obtain a copper foil-clad laminate having an insulating layer formed of a prepreg and a copper foil. The obtained copper foil-clad laminate was cut into a size of 50 mm × 50 mm to obtain a sample for measurement. The sample was allowed to stand in a

thermostatic bath at 120°C for 1 hour as a pretreatment of the obtained sample, and then floated in a solder bath at 300°C and allowed to stand for 30 minutes to perform evaluation. After a lapse of 30 minutes, it was confirmed whether or not delamination had occurred on the copper foil of the sample, between the samples, and between the prepreg layers of the sample. The case where delamination did not occur was defined as "A", and the case where delamination occurred was defined as "B".

[Water absorption rate]

Nine prepregs obtained in Examples 1 to 8 and Comparative Examples 1 to 5 were laminated and a copper foil (3EC-VLP, thickness 12 μm) was disposed on each of the upper and lower surfaces thereof, and lamination molding (thermal curing) was performed at a pressure of 30 kgf/cm$^2$ and a temperature of 230°C for 100 minutes to obtain a copper foil-clad laminate having an insulating layer formed of a prepreg and a copper foil. The obtained copper-clad laminate was subjected to etching to remove the copper foil and was cut into a size of 50 × 50 mm to obtain a sample for measurement. The sample was allowed to stand in a thermostatic bath at 120°C for 1 hour as a pretreatment of the obtained sample, and then weighed to obtain a weight A (g). After the weighed sample was allowed to stand in a thermohygrostat bath at 85°C and 85% RH for 1 week, and then weighed to obtain a weight B (g). The water absorption rate was evaluated by the following formula:

$$\text{Water absorption rate (\%)} = (B-A)/A \times 100 \quad \text{formula}$$

[Stiffness]

A copper foil (3EC-VLP, thickness 12 μm) was disposed on each of the upper and lower surfaces of one prepreg obtained in Examples 1 to 8 and Comparative Examples 1 to 5, and lamination molding (thermal curing) was performed at a pressure of 30 kgf/cm$^2$ and a temperature of 230°C for 100 minutes to obtain a copper foil-clad laminate having a predetermined insulating layer thickness. The obtained copper-clad laminate was subjected to etching to remove the copper foil and was cut into a size of 20 × 200 mm to obtain a sample for measurement. The sample for measurement was installed so as to protrude 50 mm from the measuring table, and the maximum value of the amount of flexure in the cantilever was defined as the amount of flexure.

[Table 1]

| | | Example 1 | Example 2 | Example 3 | Example 4 | Example 5 | Example 6 | Example 7 | Example 8 |
|---|---|---|---|---|---|---|---|---|---|
| Storage modulus (GPa) | E' (40) | 20 | 20 | 16 | 19 | 18 | 19 | 20 | 19 |
| | E' (170) | 16 | 18 | 14 | 16 | 15 | 16 | 17 | 17 |
| | E' (230) | 10 | 12 | 9 | 9 | 9 | 8 | 10 | 9 |
| | E' (260) | 9 | 10 | 7 | 8 | 8 | 8 | 9 | 8 |
| 0.80<b/a<0.95 | | 0.82 | 0.89 | 0.84 | 0.84 | 0.8 | 0.84 | 0.86 | 0.88 |
| 0.40<c/a<0.65 | | 0.5 | 0.61 | 0.53 | 0.47 | 0.51 | 0.44 | 0.48 | 0.45 |
| 0.40<d/a<0.65 | | 0.45 | 0.51 | 0.41 | 0.42 | 0.45 | 0.41 | 0.43 | 0.4 |
| Tg | (°C) | 195 | 214 | 195 | 195 | 178 | 191 | 208 | 207 |
| Amount of warpage | Bimetal method (mm) | 1.5 | 1.9 | 1.4 | 1.7 | 1.5 | 1.7 | 1.6 | 1.8 |
| | Multilayer coreless panel (mm) | 0.8 | 1.1 | 0.7 | 1 | 1 | 1.1 | 0.9 | 0.9 |
| Heat resistance | | A | A | A | A | A | A | A | A |
| Water absorption rate | (%) | 0.3 | 0.3 | 0.3 | 0.3 | 0.4 | 0.3 | 0.4 | 0.4 |

(continued)

| | | Example 1 | Example 2 | Example 3 | Example 4 | Example 5 | Example 6 | Example 7 | Example 8 |
|---|---|---|---|---|---|---|---|---|---|
| Stiffness | (mm) | 8 | 9 | 13 | 12 | 8 | 9 | 10 | 9 |
| * In the table, E'(x) (X = 40, 170, 230, 260) represents the storage modulus at x°C. | | | | | | | | | |

[Table 2]

| | | Comparative Example 1 | Comparative Example 2 | Comparative Example 3 | Comparative Example 4 | Comparative Example 5 |
|---|---|---|---|---|---|---|
| Storage modulus (GPa) | E' (40) | 20 | 18 | 18 | 11 | 8 |
| | E' (170) | 18 | 13 | 18 | 10 | 7 |
| | E' (230) | 14 | 8 | 17 | 8 | 5 |
| | E' (260) | 8 | 8 | 16 | 8 | 4 |
| 0.80<b/a<0.95 | | 0.9 | 0.68 | 0.98 | 0.9 | 0.91 |
| 0.40<c/a<0.65 | | 0.71 | 0.45 | 0.94 | 0.74 | 0.73 |
| 0.40<d/a<0.65 | | 0.41 | 0.43 | 0.88 | 0.69 | 0.51 |
| Tg | (°C) | 305 | 163 | 350< | 278 | 278 |
| Amount of warpage | Bimetal method (mm) | 4.5 | 2.1 | 8 | 1.8 | 1.8 |
| | Multilayer coreless panel (mm) | 1.8 | 1.2 | 6 | 0.9 | 0.9 |
| Heat resistance | | A | B | A | B | B |
| Water absorption rate | (%) | 0.4 | 0.3 | 0.6 | 0.8 | 0.8 |
| Stiffness | (mm) | 8 | 11 | 11 | 33 | 48 |
| * In the table, E'(x) (X = 40, 170, 230, 260) represents the storage modulus at x°C. | | | | | | |

This application is based on Japanese Patent Application No. 2017-250350 filed in the Japan Patent Office on December 27, 2017.

## Claims

1. A resin composition comprising at least an organic resin, wherein the resin composition satisfies relationships represented by the following formulas (i), (ii), (iii), and (x):

$$0.80 \leq b/a \leq 0.95 \ldots (i);$$

$$0.40 \leq c/a \leq 0.65 \ldots (ii);$$

$$13 \leq a \leq 25 \ldots (iii);$$

and

$$175 \leq Tg \leq 215 \ldots (x),$$

wherein a, b, and c represent storage moduli at 40°C, 170°C, and 230°C, respectively, (unit: GPa) of a cured product obtained by curing a prepreg obtained by impregnating or coating a base material with the resin composition, and Tg represents a glass transition temperature (unit: °C) of the cured product,
wherein the organic resin comprises one or more selected from the group consisting of cyanate compounds and phenolic compounds, and two or more selected from the group consisting of epoxy compounds and maleimide compounds, and
wherein the storage moduli and glass transition temperature of the cured product are measured by a dynamic mechanical analysis method in accordance with JIS C6481
**characterized in that** the organic resin comprises two or more of the epoxy compounds, and the two or more epoxy compounds comprise a naphthalene-based epoxy resin comprising a naphthalene skeleton and an aralkyl-based epoxy resin.

**2.** The resin composition according to claim 1, further satisfying a relationship represented by the following formula (iv):

$$0.40 \leq d/a \leq 0.65 \ldots (iv),$$

wherein d represents a storage modulus at 260°C (unit: GPa) of a cured product obtained by curing a prepreg obtained by impregnating or coating a base material with the resin composition, and a is defined as above.

**3.** The resin composition according to claim 1 or 2, wherein the organic resin comprises one or more of the phenolic compounds and one or more selected from the group consisting of the epoxy compounds and the maleimide compounds.

**4.** The resin composition according to any one of claims 1 to 3, further comprising a filler, wherein a content of the filler is 100 parts by mass or more and 700 parts by mass or less based on 100 parts by mass of a resin solid content in the resin composition.

**5.** The resin composition according to claim 4, wherein the filler comprises one or more inorganic fillers selected from the group consisting of silica, boehmite, and alumina.

**6.** The resin composition according to claim 4 or 5, wherein the filler comprises an inorganic filler and an organic filler.

**7.** The resin composition according to any one of claims 1 to 6, which is used for a metal foil-clad laminate.

**8.** The resin composition according to any one of claims 1 to 6, which is used for a printed wiring board.

**9.** The resin composition according to any one of claims 1 to 6, which is used for a multilayer printed wiring board.

**10.** A prepreg comprising:

a base material; and
the resin composition according to any one of claims 1 to 6 with which the base material is impregnated or coated.

**11.** The prepreg according to claim 10, wherein the base material is a glass base material.

**12.** The prepreg according to claim 11, wherein the glass base material is made of a fiber of one or more glasses selected from the group consisting of E glass, D glass, S glass, T glass, Q glass, L glass, NE glass, and HME glass.

**13.** A laminate comprising the prepreg according to any one of claims 10 to 12.

**14.** A metal foil-clad laminate comprising:

the prepreg according to any one of claims 10 to 12; and
a metal foil disposed on one or both sides of the prepreg.

**15.** A printed wiring board comprising:

an insulating layer formed of the prepreg according to any one of claims 10 to 12; and
a conductor layer disposed on a surface of the insulating layer.

**16.** A multilayer printed wiring board, comprising:

a plurality of insulating layers comprising:

a first insulating layer; and
one or more second insulating layers laminated on one side of the first insulating layer; and

a plurality of conductor layers comprising:

a first conductor layer disposed between adjacent two of the plurality of insulating layers; and
a second conductor layer disposed on a surface of an outermost layer of the plurality of insulating layers,

wherein each of the first insulating layer and the second insulating layer has a cured product of the prepreg according to any one of claims 10 to 12.

**Patentansprüche**

**1.** 1. Harzzusammensetzung, umfassend mindestens ein organisches Harz, wobei die Harzzusammensetzung Bedingungen erfüllt, die durch die folgenden Formeln (i), (ii), (iii) und (x) dargestellt sind:

$$0{,}80 \leq b/a \leq 0{,}95 \ ... \ (i);$$

$$0{,}40 \leq c/a \leq 0{,}65 \ ... \ (ii);$$

$$13 \leq a \leq 25 \ ... \ (iii);$$

und

$$175 \leq Tg \leq 215 \ ... \ (x),$$

wobei a, b und c Speichermodule bei 40°C, 170°C, bzw. 230°C (Einheit: GPa) eines gehärteten Produkts darstellen, das durch Härten eines Prepregs erhalten wird, das durch Imprägnieren oder Beschichten eines Basismaterials mit der Harzzusammensetzung erhalten wird, und Tg eine Glasübergangstemperatur (Einheit: °C) des gehärteten Produkts darstellt,
wobei das organische Harz umfasst eine oder mehrere, ausgewählt aus der Gruppe, bestehend aus Cyanatverbindungen und Phenolverbindungen, und zwei oder mehrere, ausgewählt aus der Gruppe, bestehend aus Epoxidverbindungen und Maleimidverbindungen, und
wobei die Speichermodule und die Glasübergangstemperatur des gehärteten Produkts durch ein dynamisch-mechanisches Analyseverfahren in Übereinstimmung mit JIS C6481 gemessen werden,
**dadurch gekennzeichnet, dass** das organische Harz umfasst zwei oder mehr der Epoxyverbindungen, und die zwei oder mehr Epoxyverbindungen umfassen ein Epoxyharz auf Naphthalinbasis umfassend ein Naphthalinskelett und ein Epoxyharz auf Aralkylbasis.

**2.** Harzzusammensetzung gemäß Anspruch 1, die ferner eine Bedingung erfüllt, die durch die folgende Formel (iv) dargestellt wird:

$$0{,}40 \leq d/a \leq 0{,}65 \ ... \ (iv),$$

wobei d ein Speichermodul bei 260°C (Einheit: GPa) eines gehärteten Produkts darstellt, das durch Härten eines

Prepregs erhalten wird, das durch Imprägnieren oder Beschichten eines Basismaterials mit der Harzzusammensetzung erhalten wird, und a wie oben definiert ist.

**3.** Harzzusammensetzung gemäß Anspruch 1 oder 2, wobei das organische Harz umfasst eine oder mehrere der Phenolverbindungen und eine oder mehrere, ausgewählt aus der Gruppe, bestehend aus den Epoxidverbindungen und den Maleimidverbindungen umfasst.

**4.** Harzzusammensetzung gemäß mindestens einem der Ansprüche 1 bis 3, ferner umfassend einen Füllstoff, wobei der Gehalt des Füllstoffs 100 Masseteile oder mehr und 700 Masseteile oder weniger beträgt, bezogen auf 100 Masseteile eines Harzfeststoffgehalts in der Harzzusammensetzung.

**5.** Harzzusammensetzung gemäß Anspruch 4, wobei der Füllstoff umfasst einen oder mehrere anorganische Füllstoffe, ausgewählt aus der Gruppe, bestehend aus Siliciumdioxid, Böhmit und Aluminiumoxid.

**6.** Harzzusammensetzung gemäß Anspruch 4 oder 5, wobei der Füllstoff einen anorganischen Füllstoff und einen organischen Füllstoff umfasst.

**7.** Harzzusammensetzung gemäß mindestens einem der Ansprüche 1 bis 6, die für ein Metallfolienplattiertes Laminat verwendet wird.

**8.** Harzzusammensetzung gemäß mindestens einem der Ansprüche 1 bis 6, die für eine gedruckte Leiterplatte verwendet wird.

**9.** Harzzusammensetzung gemäß mindestens einem der Ansprüche 1 bis 6, die für eine mehrschichtige gedruckte Leiter platte verwendet wird.

**10.** Prepreg, umfassend:

ein Basismaterial; und
die Harzzusammensetzung gemäß mindestens einem der Ansprüche 1 bis 6, mit der das Basismaterial imprägniert oder beschichtet ist.

**11.** Prepreg gemäß Anspruch 10, wobei das Basismaterial ein Glasbasismaterial ist.

**12.** Prepreg gemäß Anspruch 11, wobei das Glasbasismaterial aus einer Faser aus einem oder mehreren Gläsern, ausgewählt aus der Gruppe, bestehend aus E-Glas, D-Glas, S-Glas, T-Glas, Q-Glas, L-Glas, NE-Glas und HME-Glas, hergestellt ist.

**13.** Laminat, umfassend das Prepreg gemäß mindestens einem der Ansprüche 10 bis 12.

**14.** Metallfolienplattiertes Laminat, umfassend:

das Prepreg gemäß mindestens einem der Ansprüche 10 bis 12; und
eine Metallfolie, die auf einer oder beiden Seiten des Prepregs angeordnet ist.

**15.** Gedruckte Leiterplatte, umfassend:

eine aus dem Prepreg gemäß mindestens einem der Ansprüche 10 bis 12 gebildete Isolierschicht; und
eine auf einer Oberfläche der Isolierschicht angeordnete Leiterschicht.

**16.** Mehrschichtige Leiterplatte, umfassend:

eine Vielzahl von Isolierschichten, umfassend:

eine erste Isolierschicht; und
eine oder mehrere zweite Isolierschichten, die auf eine Seite der ersten Isolierschicht laminiert sind; und eine Vielzahl von Leiterschichten, umfassend:

eine erste Leiterschicht, die zwischen zwei benachbarten der Vielzahl von Isolierschichten angeordnet ist; und
eine zweite Leiterschicht, die auf einer Oberfläche einer äußersten Schicht der Vielzahl von Isolierschichten angeordnet ist,

wobei jede der ersten Isolierschicht und der zweiten Isolierschicht ein gehärtetes Produkt des Prepregs gemäß mindestens einem der Ansprüche 10 bis 12 aufweist.

## Revendications

**1.** Composition de résine comprenant au moins une résine organique, dans laquelle la composition de résine satisfait à des relations représentées par les formules (i), (ii), (iii) et (x) suivantes :

$$0{,}80 \leq b/a \leq 0{,}95 \ldots \quad (i)\ ;$$

$$0{,}40 \leq c/a \leq 0{,}65 \ldots \quad (ii)\ ;$$

$$13 \leq a \leq 25 \ldots \qquad (iii)\ ;$$

et

$$175 \leq Tg \leq 215 \ldots \qquad (x),$$

dans laquelle a, b et c représentent des modules de stockage à 40 °C, 170 °C et 230 °C, respectivement (unité : GPa) d'un produit durci obtenu par durcissement d'un préimprégné obtenu par imprégnation ou revêtement d'un matériau de base avec la composition de résine, et Tg représente une température de transition vitreuse (unité : °C) du produit durci,
dans laquelle la résine organique comprend un ou plusieurs composés sélectionnés parmi le groupe consistant en des composés de cyanate et des composés phénoliques, et deux composés ou plus sélectionnés parmi le groupe consistant en des composés époxy et des composés de maléimide, et
dans laquelle les modules de stockage et la température de transition vitreuse du produit durci sont mesurés par un procédé d'analyse mécanique dynamique conformément à la norme JIS C6481 **caractérisée en ce que** la résine organique comprend deux ou plus des composés époxy, et les deux composés époxy ou plus comprennent une résine époxy à base de naphtalène comprenant un squelette de naphtalène et une résine époxy à base d'aralkyle.

**2.** Composition de résine selon la revendication 1, satisfaisant en outre à une relation représentée par la formule (iv) suivante :

$$0{,}40 \leq d/a \leq 0{,}65 \ldots \quad (iv),$$

dans laquelle d représente un module de stockage à 260 °C (unité : GPa) d'un produit durci obtenu par durcissement d'un préimprégné obtenu par imprégnation ou revêtement d'un matériau de base avec la composition de résine, et a est défini tel que ci-dessus.

**3.** Composition de résine selon la revendication 1 ou 2, dans laquelle la résine organique comprend un ou plusieurs des composés phénoliques et un ou plusieurs composés sélectionnés parmi le groupe consistant en les composés époxy et les composés de maléimide.

**4.** Composition de résine selon l'une quelconque des revendications 1 à 3, comprenant en outre une charge, dans laquelle une teneur de la charge est 100 parties en masse ou plus et 700 parties en masse ou moins sur la base de 100 parties en masse d'une teneur en solides de résine dans la composition de résine.

5. Composition de résine selon la revendication 4, dans laquelle la charge comprend une ou plusieurs charges inorganiques sélectionnées parmi le groupe consistant en la silice, la boehmite, et l'alumine.

6. Composition de résine selon la revendication 4 ou 5, dans laquelle la charge comprend une charge inorganique et une charge organique.

7. Composition de résine selon l'une quelconque des revendications 1 à 6, qui est utilisée pour un stratifié plaqué d'une feuille métallique.

8. Composition de résine selon l'une quelconque des revendications 1 à 6, qui est utilisée pour une carte de circuit imprimé.

9. Composition de résine selon l'une quelconque des revendications 1 à 6, qui est utilisée pour une carte de circuit imprimé multicouche.

10. Préimprégné comprenant :

    un matériau de base ; et
    la composition de résine selon l'une quelconque des revendications 1 à 6 avec laquelle le matériau de base est imprégné ou revêtu.

11. Préimprégné selon la revendication 10, dans lequel le matériau de base est un matériau à base de verre.

12. Préimprégné selon la revendication 11, dans lequel le matériau à base de verre est constitué d'une fibre d'un ou de plusieurs verres sélectionnés parmi le groupe consistant en du verre E, du verre D, du verre S, du verre T, du verre Q, du verre L, du verre NE, et du verre HME.

13. Stratifié comprenant le préimprégné selon l'une quelconque des revendications 10 à 12.

14. Stratifié plaqué d'une feuille métallique comprenant :

    le préimprégné selon l'une quelconque des revendications 10 à 12 ; et
    une feuille métallique disposée sur un côté ou les deux côtés du préimprégné.

15. Carte de circuit imprimé comprenant :

    une couche isolante formée du préimprégné selon l'une quelconque des revendications 10 à 12 ; et
    une couche conductrice disposée sur une surface de la couche isolante.

16. Carte de circuit imprimé multicouche, comprenant :

    une pluralité de couches isolantes comprenant :

        une première couche isolante ; et
        une ou plusieurs secondes couches isolantes stratifiées sur un côté de la première couche isolante ; et

    une pluralité de couches conductrices comprenant :

        une première couche conductrice disposée entre deux couches adjacentes de la pluralité de couches isolantes ; et
        une seconde couche conductrice disposée sur une surface d'une couche la plus extérieure de la pluralité de couches isolantes,

    dans laquelle chacune de la première couche isolante et de la seconde couche isolante présente un produit durci du préimprégné selon l'une quelconque des revendications 10 à 12.

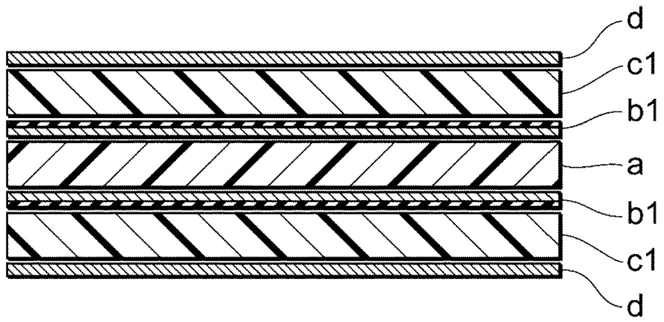


Fig.1

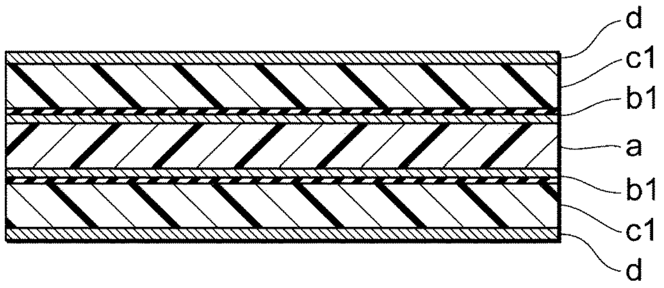


Fig.2

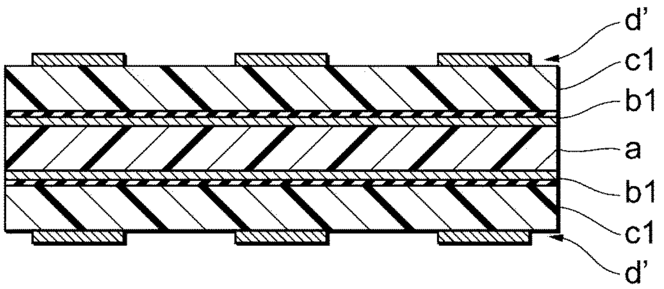


Fig.3

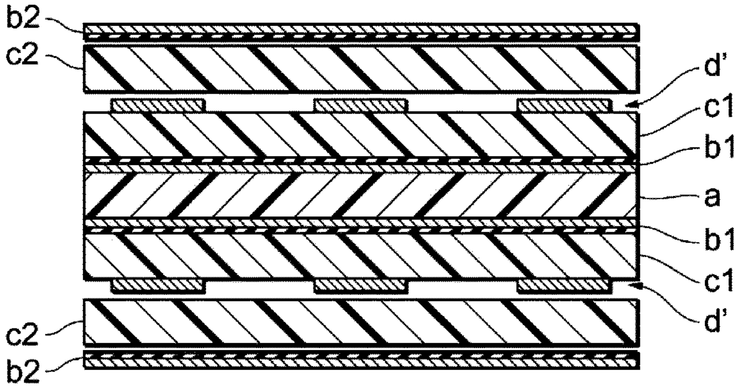


Fig.4

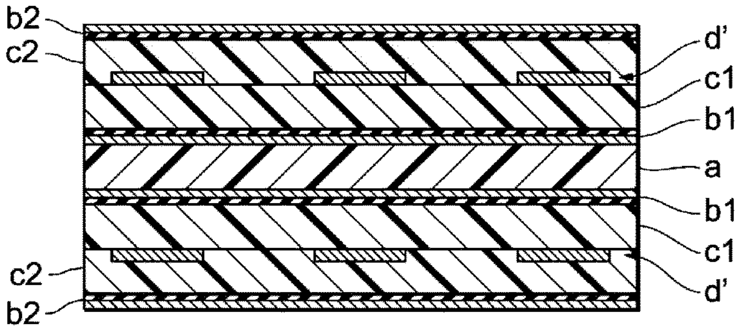


Fig.5

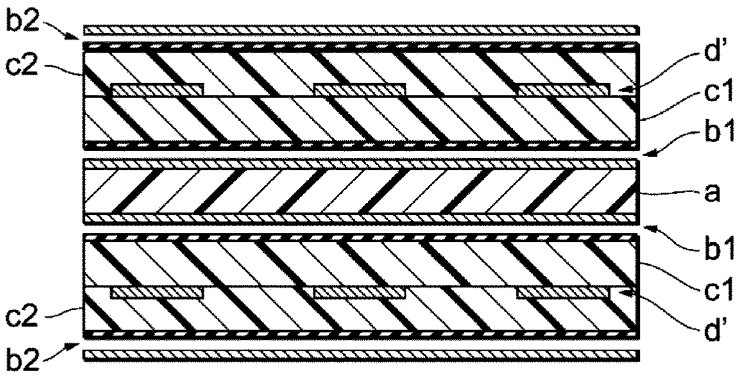


Fig.6

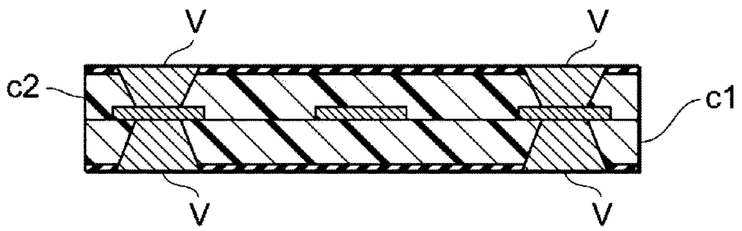


Fig.7

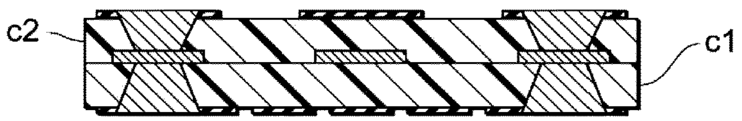


Fig.8

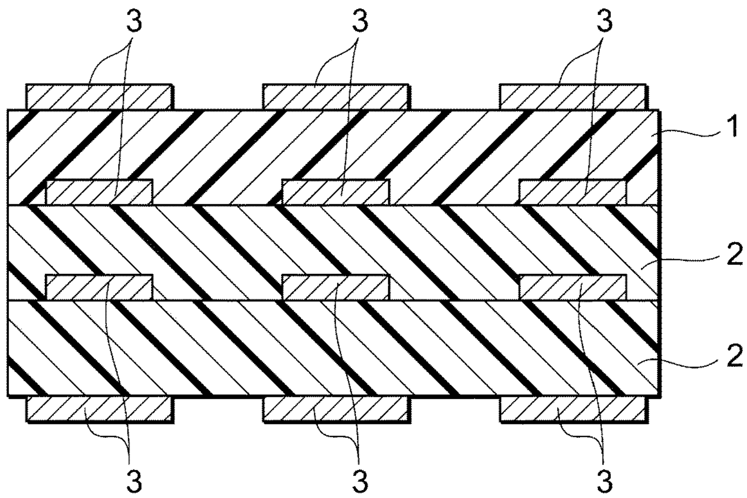


Fig.9

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- EP 2947122 A1
- US 20150017450 A1
- US 20160108230 A1
- JP 2014037485 A
- JP 2016040391 A
- JP 2013129827 A
- JP 2017193614 A
- JP 5056787 B
- JP 2015174874 A
- JP 2017250350 A